# EUROPÄISCHE PATENTSCHRIFT

(11) **EP 0 799 832 B1**
(45) Veröffentlichungstag und Bekanntmachung des Hinweises auf die Patenterteilung: **14.01.2004**
(21) Anmeldenummer: 97104202.3
(22) Anmeldetag: 13.03.1997
(51) Int. Cl.: C07F 7/12, C07F 7/18, C07F 7/04

(54) **Hydrolysierbare, fluorierte Silane, Verfahren zu deren Herstellung und deren Verwendung zur Herstellung von Kieselsäurepolykondensaten und Kieselsäreheteropolykondensaten**
Hydrolysable fluorinated silanes; process for their preparation and their use in preparing silicic acid polycondensates and silicic acid heteropolycondensates
Silanes fluorées hydrolysables, procédé pour les préparer et leur utilisation pour la production de polycondensats d'acide silicique et d'hétéropolycondensats d'acide silicique

(30) Priorität: 04.04.1996 DE 19613650
(43) Veröffentlichungstag der Anmeldung: 08.10.1997
(73) Patentinhaber: Fraunhofer-Gesellschaft zur Förderung der angewandten Forschung e.V., 80686 München (DE)
(72) Erfinder: Roscher, Christof, Dipl.-Chem., 97080 Würzburg (DE); Popall, Michael, Dr. rer. nat., 97072 Würzburg (DE); Olsowski, Birke-E., 97209 Veitshöchheim (DE)
(74) Vertreter: Olgemöller, Luitgard, Dr.

(56) Entgegenhaltungen:
- WO-A-82/03397
- DE-A- 3 407 087
- DE-A- 3 536 716
- DE-A- 3 825 002
- CHEMICAL ABSTRACTS, vol. 75, no. 1, 5. Juli 1971 (1971-07-05) Columbus, Ohio, US; abstract no. 6081, KLEBANSKII, A. L. ET AL: "Silicon polyfluoroaromatic derivatives" XP002116200 & SU 276 957 1 (KLEBANSKII, A. L.;YUZHELEVSKII, YU. A.; KAGAN, E. G.; KHARLAMOVA, A. V)
- PATWARDHAN, DINESH V. ET AL: "Synthesis and surface properties of poly(3,5- difluorophenylmethylsiloxane)" POLYM. PREPR. (AM. CHEM. SOC., DIV. POLYM. CHEM.) (1996), 37(2), 294-295 ,1996, XP002116199
- CHEMICAL ABSTRACTS, vol. 125, no. 26, 23. Dezember 1996 (1996-12-23) Columbus, Ohio, US; abstract no. 336678, ROSCHER, C. ET AL: "Perfluoroaryl substituted inorganic-organic hybrid materials" XP002116201 & MATER. RES. SOC. SYMP. PROC. (1996), 435(BETTER CERAMICS THROUGH CHEMISTRY VII: ORGANIC/INORGANIC HYBRID MATERIALS), 547-552 ,1996,
- GIORI C. ET AL: 'Perfluoroaromatic Polysiloxanes' POLYMER PREPRINTS, AMERICAN CHEMICAL SOCIETY Bd. 37, Nr. 2, 1996 - 1996, Seiten 139 - 148

## Beschreibung

Die Erfindung betrifft hydrolysierbare, fluorierte Silane, Verfahren zu deren Herstellung sowie deren Verwendung zur Herstellung von Kieselsäurepolykondensaten und Kieselsäureheteropolykondensaten.

Hydrolysierbare, organisch modifizierte Silane finden eine breite Anwendung bei der Herstellung kratzfester Beschichtungen für die unterschiedlichsten Substrate, für die Herstellung von Füllstoffen, von Klebe- und Dichtungsmassen oder von Formkörpern. Dabei werden diese Silane entweder alleine, in Mischungen oder in Gegenwart weiterer hydrolysierbarer und/oder kondensierbarer Komponenten hydrolytisch kondensiert, wobei die endgültige Härtung durch Polymerisation, Polyaddition oder Polykondensation, meist thermisch, photochemisch, kovalent-nucleophil oder redoxinduziert erfolgt.

So sind z.B. aus der DE 3407087 C2 kratzfeste Beschichtungen bekannt, die durch hydrolytische Kondensation einer Mischung entstehen, die u.a. aus einer hydrolysierbaren Titan- oder Zirkon-Verbindung und aus einem hydrolysierbaren, organofunktionellen Silan R'ₘ(R''Y)ₙSiX₍₄₋ₘ₋ₙ₎ besteht, wobei R' z.B. Alkyl oder Alkenyl ist, R" z.B. Alkylen oder Alkenylen und X einen hydrolysierbaren Rest darstellt. Nachteil dieser Beschichtungen sind jedoch deren ungenügende optische Eigenschaften, so daß deren Einsatz für optische oder optoelektronische Anwendungen nur bedingt möglich ist.

Aus der DE 3536716 A1 sind z.B. Klebe- und Dichtungsmassen bekannt, die erhalten worden sind durch hydrolytische Kondensation eines oder mehrerer Organosilane der allgemeinen Formel RₘSiX₄₋ₘ und gegebenenfalls einer oder mehrerer der Komponenten SiX₄ und/oder Rₙ(R''Y)ₚSiX₄₋ₙ₋ₚ, wobei R und R" z.B. Alkyl, Alkenyl, Aryl, Alkylaryl, Arylalkyl, Alkenylaryl oder Arylalkenyl, X z.B. Wasserstoff, Halogen, Hydroxy, Alkoxy oder Acyloxy bedeutet, und Y z.B. ein Halogen oder eine gegebenenfalls substituierte Amino-, Amid-, Aldehyd-, Alkylcarbonyl-, Carboxy-, Hydroxy-, Mercapto- oder Cyano-Gruppe darstellt. Nachteil dieser Klebe- und Dichtungsmassen sind jedoch ebenfalls deren ungenügende optische Eigenschaften, so daß deren Einsatz für optische oder optoelektronische Anwendungen auch nur bedingt möglich ist.

Von M. Weidenbruch (Chemiker-Zeitung, 97. Jahrgang (1973) Nr. 3, 116 - 122) werden (Polyfluorphenyl)silane beschrieben. Diese Silane sind jedoch nur zum Teil hydrolysierbar und weisen außerdem im Molekül keine Funktionalitäten auf, so daß diese Silane für die Herstellung von Kieselsäure(hetero)polykondensaten völlig ungeeignet sind.

In der OS 38 25 002 werden fluorierte Phenylgruppen enthaltende Silane als Katalysatoren für die Härtung von Epoxyharzen vorgeschlagen, die mit diesen Katalysatoren bei besonders niedrigen Temperaturen erfolgen kann.

Aus der SU 276957 sind perfluorierte Diphenylether bekannt, die einseitig oder beidseitig in Parastellung eine Dialkylsilangruppe tragen können.

C. Giori et al. in Polymer Preprints, American Chemical Society, US, 1996, Bd. 37 (2), S. 139-148 beschreiben, daß sich aus Di(pentafluorphenyl)diethoxysilan und Pentafluorphenyltriethoxysilan durch hydrolytische Kondensation Beschichtungsmaterialien erzeugen lassen, die insbesondere für die Raumfahrt verwendbar sind.

Aufgabe der vorliegenden Erfindung ist es, organisch modifizierte Silane bereit zu stellen, die hydrolysierbar sind, die alleine, in Mischungen oder zusammen mit anderen hydrolysierbaren und/oder kondensierbaren Komponenten zu kratzfesten Beschichtungen, zu Füll-, Klebe- oder Dichtungsmassen, zu Formkörpern oder zu Einbettmaterialien verarbeitet werden können. Diese Silane sollen universell einsetzbar sein, und sie sollen in ein anorganisch-organisches Verbundsystem, d.h. in ein anorganisch-organisches Netzwerk eingebaut werden können. Ferner sollen diese Silane alleine, in Mischungen oder zusammen mit anderen hydrolysierbaren und/ oder kondensierbaren Komponenten zu Kieselsäure(hetero)polykondensaten führen, die über gute Haftungs- und Temperatureigenschaften verfügen und gute optische Dämpfungswerte zeigen, so daß diese Kieselsäure(hetero)polykondensate für optische oder optoelektronische Anwendungen geeignet sind.

Gelöst wird diese Aufgabe durch Silane der Formel I

{[R'-(Y)ₑ]_{c+1}(C₆F_{4-c})(C₆F₄)_{d}}_{f}SiRₐX_{b} (I)

in der die Reste und Indices gleich oder verschieden sind und folgende Bedeutung haben:
- R =: gegebenenfalls substituiertes Alkyl, Alkenyl, Aryl, Alkylaryl oder Arylalkyl mit jeweils 1 bis 20, vorzugsweise 1 bis 15 Kohlenstoff-Atomen, wobei diese Reste durch Sauerstoffoder Schwefelatome, durch Ester-, Carbonyl-, Amid- oder Aminogruppen unterbrochen sein können;
- R'=: R'= ein organischer Rest, der 1 bis 50 Kohlenstoffatome und wenigstens eine C=C-Doppelbindung und/oder wenigstens eine Spiro-Gruppe und/oder wenigstens einen substituierten oder unsubstituierten Oxiran-Rest enthält;
- X =: Wasserstoff, Halogen, Hydroxy, Alkoxy, Acyloxy, Alkylcarbonyl, Alkoxycarbonyl oder NR"₂, mit R" = Wasserstoff, Alkyl oder Aryl;
- Y =: O, S, NH oder NR', wobei R' ein organischer Rest mit 1 bis 50 Kohlenstoff-Atomen ist;
- a =: 0, 1 oder 2;
- b =: 1, 2 oder 3;
- c =: 0 oder 1;
- d =: 0 bis 9;
- e =: 0 oder 1;
- f =: 1, 2 oder 3, mit a+b+f = 4.

Die Silane der Formel I sind über die Reste X hydrolysierbar. Über diese hydrolysierbaren Gruppen kann ein anorganisches Netzwerk mit Si-O-Si-Einheiten aufgebaut werden, während z.B. im Rest R' enthaltene Doppelbindungen, Spiro-Gruppen oder Oxiran-Reste unter Aufbau eines organischen Netzwerkes polymerisieren, polykondensieren oder polyaddieren.

Die Alkyl-Reste sind z.B. geradkettige, verzweigte oder cyclische Reste mit 1 bis 20, insbesondere mit 1 bis 10 Kohlenstoff-Atomen und vorzugsweise niedere Alkyl-Reste mit 1 bis 6, besonders bevorzugt mit 1 bis 4 Kohlenstoff-Atomen. Spezielle Beispiele sind Methyl, Ethyl, n-Propyl, i-Propyl, n-Butyl, i-Butyl, s-Butyl, t-Butyl, n-Pentyl, n-Hexyl, Cyclohexyl, 2-Ethylhexyl, Dodecyl und Octadecyl.

Die Alkenyl-Reste sind z.B. geradkettige, verzweigte oder cyclische Reste mit 2 bis 20, bevorzugt mit 2 bis 10 Kohlenstoff-Atomen und vorzugsweise niedere Alkenyl-Reste mit 2 bis 6 Kohlenstoff-Atomen, wie z.B. Vinyl, Allyl und 2-Butenyl.

Bevorzugte Aryl-Reste sind Phenyl, Biphenyl und Naphthyl. Die Alkoxy-, Acyloxy-, Alkylamino-, Dialkylamino-, Alkylcarbonyl-, Alkoxycarbonyl-, Arylalkyl-, Alkylaryl-, Alkylen- und Alkylenarylen-Reste leiten sich vorzugsweise von den oben genannten Alkyl- und Aryl-Resten ab. Spezielle Beispiele sind Methoxy, Ethoxy, n- und i-Propoxy, n-, i-, s- und t-Butoxy, Monomethylamino, Monoethylamino, Dimethylamino, Diethylamino, N-Ethylanilino, Acetyloxy, Propionyloxy, Methylcarbonyl, Ethylcarbonyl, Methoxycarbonyl, Ethoxycarbonyl, Benzyl, 2-Phenylethyl und Tolyl.

Die genannten Reste können gegebenenfalls einen oder mehrere Substituenten tragen, z.B. Halogen, Alkyl, Hydroxyalkyl, Alkoxy, Aryl, Aryloxy, Alkylcarbonyl, Alkoxycarbonyl, Furfuryl, Tetrahydrofurfuryl, Amino, Monoalkylamino, Dialkylamino, Trialkylammonium, Amido, Hydroxy, Formyl, Carboxy, Mercapto, Cyano, Isocyanato, Nitro, Epoxy, SO₃H oder PO₄H₂.

Unter den Halogenen sind Fluor, Chlor und Brom und insbesondere Chlor bevorzugt.

Für a = 2 bzw. b ≥ 2 können die Reste X und R jeweils die selbe oder eine unterschiedliche Bedeutung haben.

Ohne Einschränkung der Allgemeinheit sind Beispiele für Reste mit dem Index f (für d = 0, 1 oder 2 und mit para-ständiger Verknüpfung der Phenylen-Einheiten) :

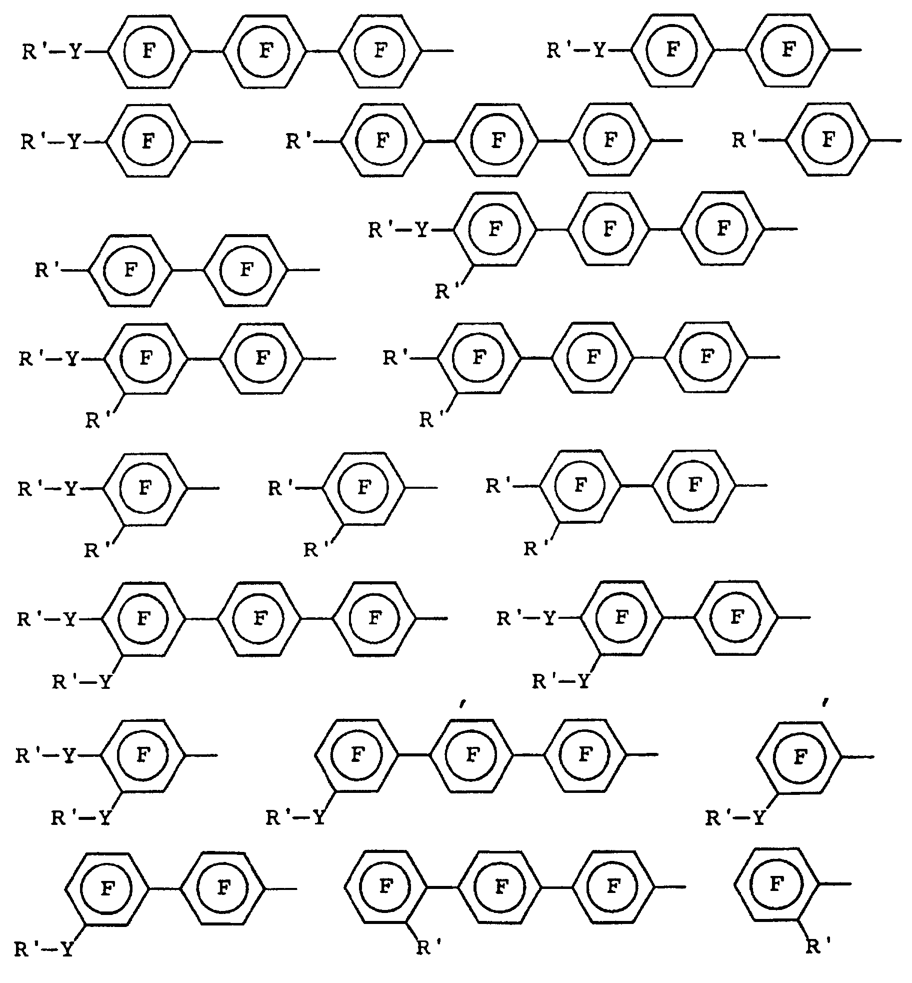

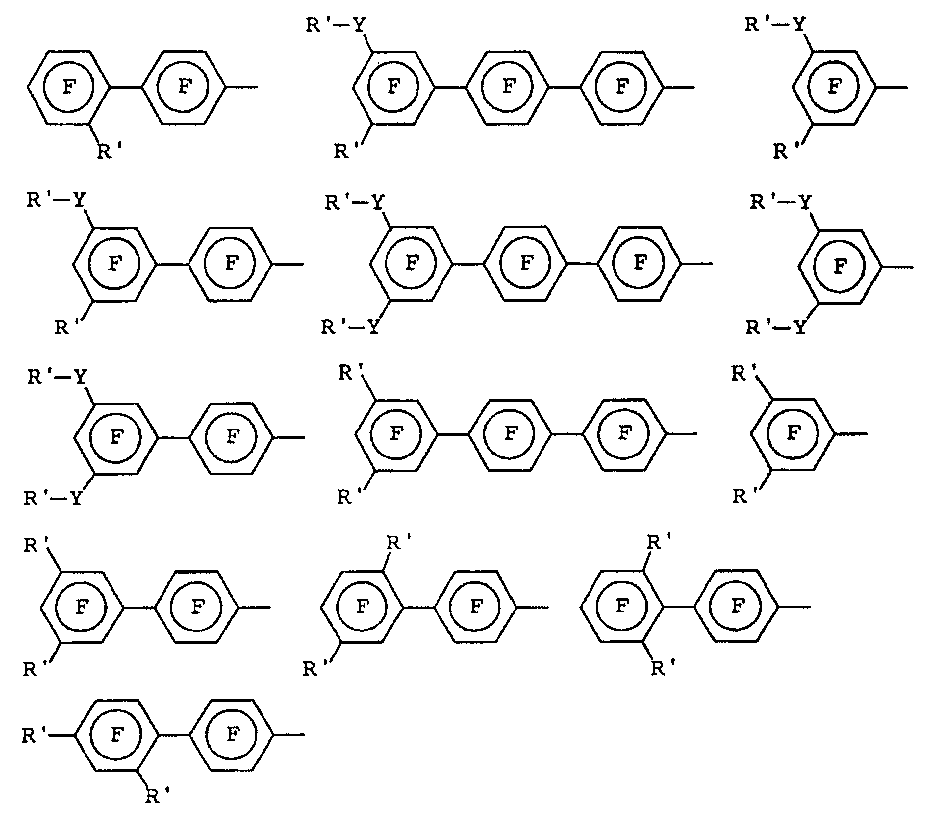

Die erfindungsgemäßen Silane enthalten substituierte (Poly)-Phenylen-Reste mit bis zu 10 Phenylen-Einheiten, wobei orthound/oder meta- und/oder para-Verknüpfung möglich ist. Phenylen-, Biphenylen- und Terphenylen-Gruppen sind bevorzugt. Gemäß den Wertevorgaben für den Index f sind in den erfindungsgemäßen Silanen bis zu 3 (Poly)Phenylen-Reste mit dem Silicium-Atom verbunden.

Der endständige Phenylen-Rest enthält bis zu zwei Reste R', die über eine Ether- und/oder Thioether- und/oder Amino-Gruppe und/oder direkt mit dem aromatischen Ringsystem verknüpft sind. Weist der endständige Phenylen-Rest zwei Substituenten auf, so ist ortho-, meta- oder para-Verknüpfung möglich.

Weist er drei Substituenten auf, so sitzen diese in 1.2.3-, 1.2.4- oder 1.3.5-Position.

Der Rest R' ist ein organischer Rest mit 1 bis 50 Kohlenstoff-Atomen. Vorzugsweise enthält der Rest R' mindestens eine C=C-Doppelbindung, wie z.B. Vinyl-, Allyl-, Acryl-, und/oder Methacrylgruppen, und 2 bis 50, vorzugsweise 2 bis 30 Kohlenstoff-Atome. Vorzugsweise enthält R' zwei oder mehrere Acrylat- und/oder Methacrylat-Gruppen. Konkrete Beispiele für derartige Reste R' sind:

H₂C=CH― H₂C=CH―CH₂― H₃C―CH=CH― H₃C―CH=CH―CH₂―

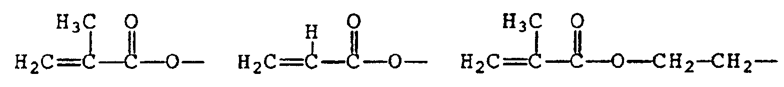

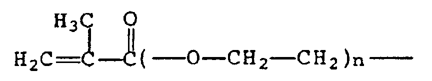

mit n = 1 bis 9 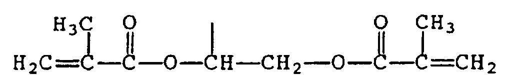 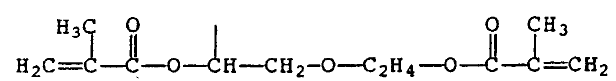 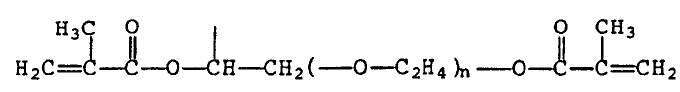 mit n = 2 - 9 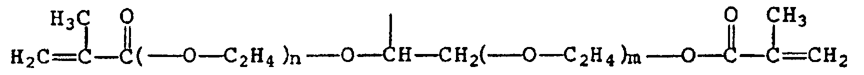 mit m = 1 - 6 und n = 1 - 6 und m + n = 2 - 8 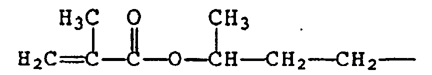 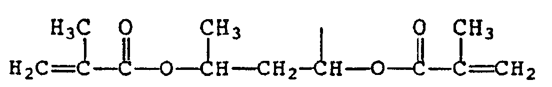 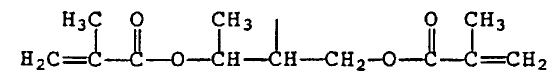 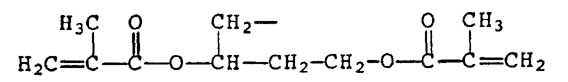 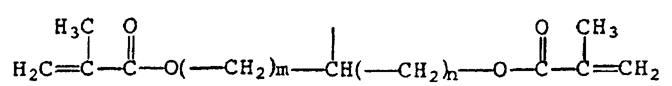 mit n und m gleich 0 bis 11 und m + n = 0 bis 11 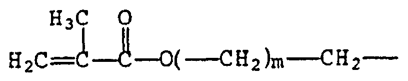 mit m = 1 - 11 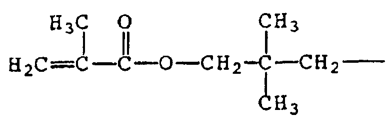 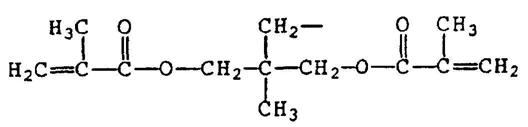 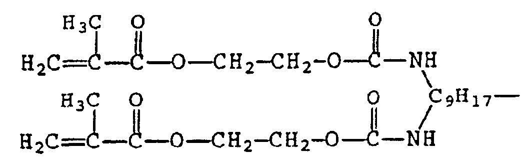 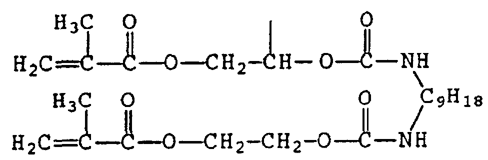 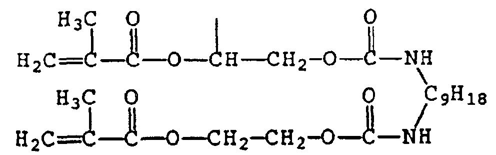 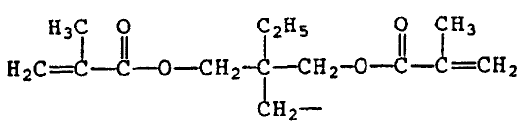 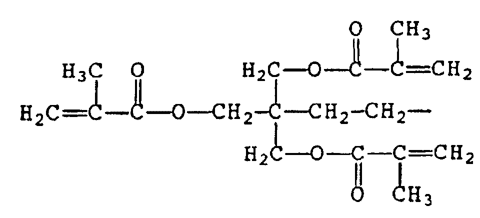 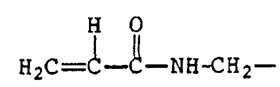 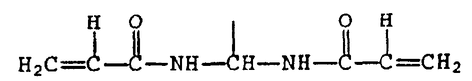 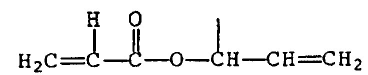 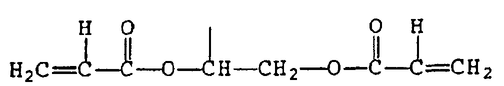 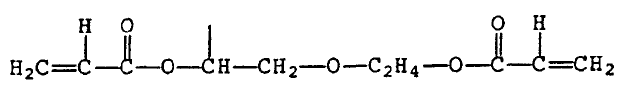 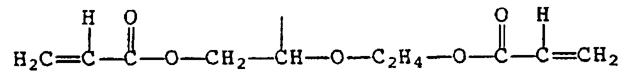 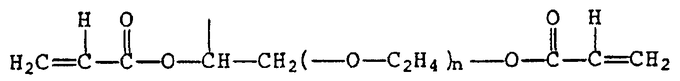 mit n = 2 - 9 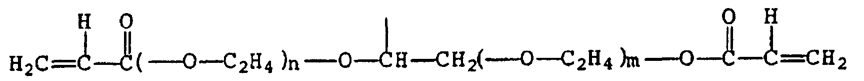 mit m = 1 - 6 und n = 1 - 6 und m + n = 2 - 8 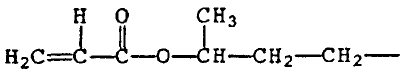 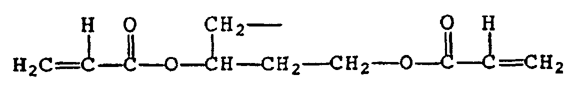 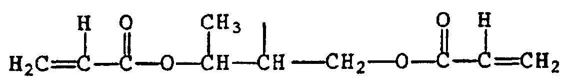 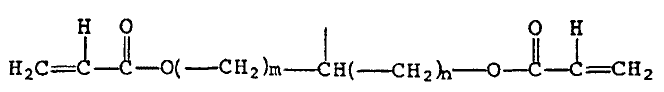 mit n und m gleich 0 bis 11 und m + n = 0 bis 11 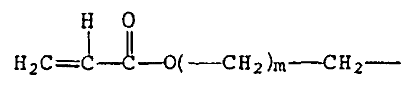 mit m = 1 - 11

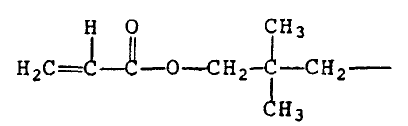

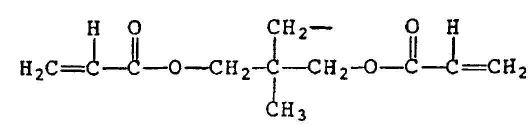

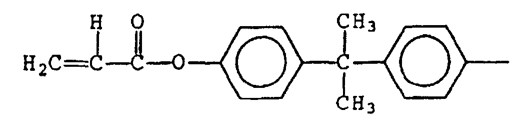

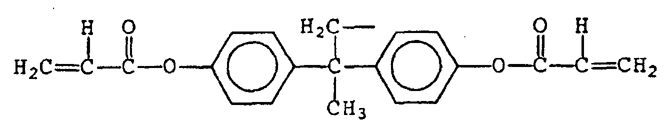

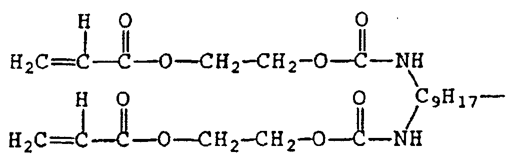

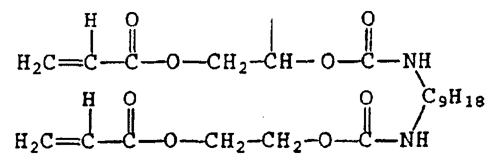

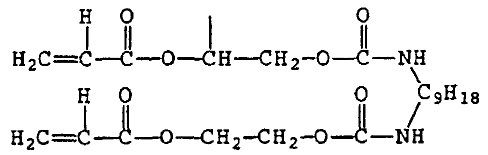

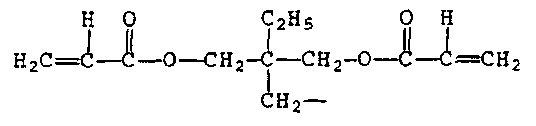

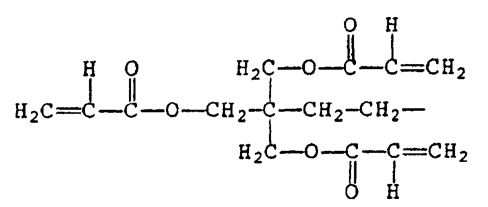

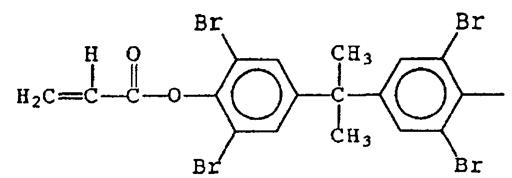

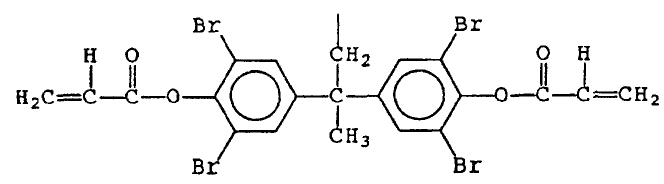

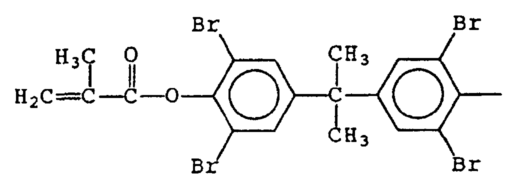

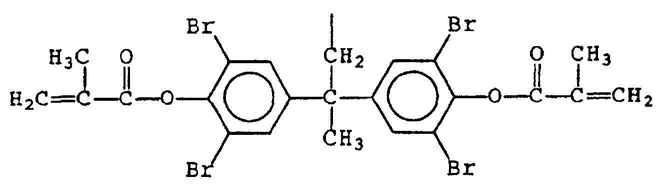

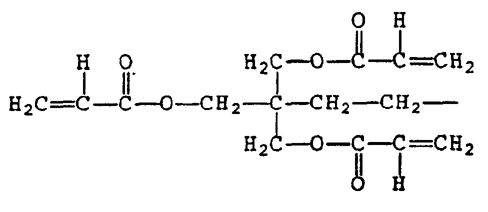

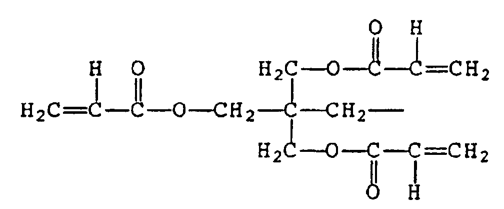

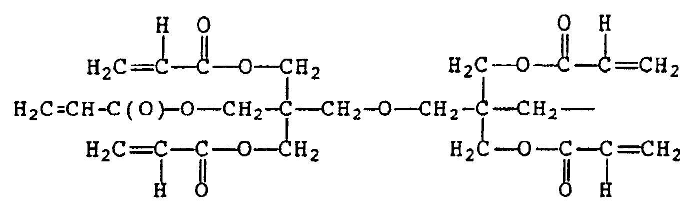

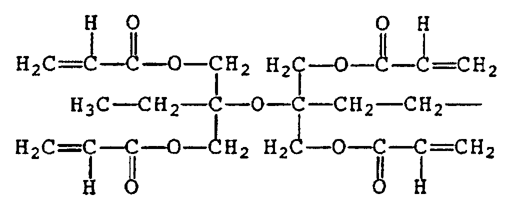

Ferner ist es bevorzugt, wenn der Rest R' eine oder mehrere Spiro-Gruppen enthält. Ohne Einschränkung der Allgemeinheit sind konkrete Beispiele für derartige Reste R':

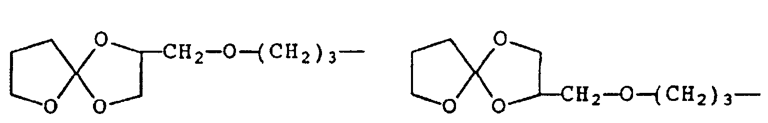

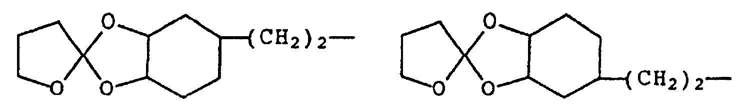

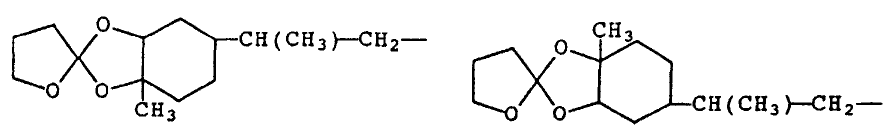

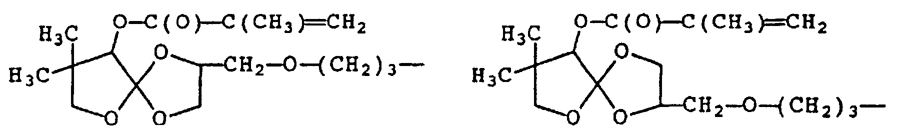

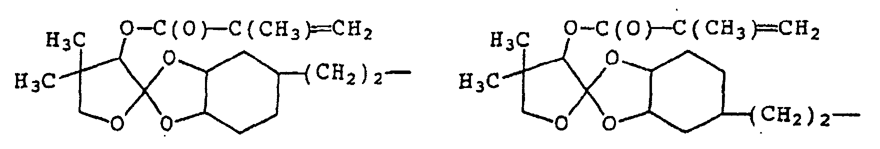

Desweiteren ist es bevorzugt, wenn der Rest R' eine oder mehrere substituierte oder unsubstituierte Oxiran-Ringe enthält. Ohne Einschränkung der Allgemeinheit sind konkrete Beispiele hierfür

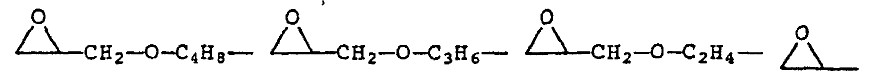

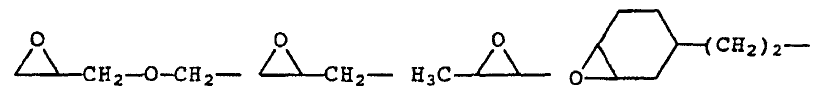

Weitere bevorzugte Ausführungsformen des Restes R' enthalten wenigsten einen perfluorierten Alkyl-, Alkenyl- oder Aryl-Rest. Ohne Einschränkung der Allgemeinheit sind konkrete Beispiele für derartige Reste R' : CF₃, C₂F₃, C₂F₅, i-C₃F₇, n-C₃F₇, n-C₄F₉, i-C₄F₉, s-C₄F₉ oder t-C₄F₉.

In weiteren Ausführungsformen enthalten die erfindungsgemäßen Silane mehr als ein Silicium-Atom im Molekül, d.h. einer oder mehrere Reste R' enthalten die Gruppierung SiR_{g}X_{3-g} oder SiRₕX₂₋ₕ, mit g = 0, 1, 2 oder 3 und h = 0, 1 oder 2. Ist g < 3 oder h < 2, so weisen diese Gruppen hydrolysierbare Reste X auf und die erfindungsgemäßen Silane sind auch über diese Reste in ein anorganisches Netzwerk einbaubar. Ohne Einschränkung der Allgemeinheit sind allgemeine Formeln für derartige Silane

{[X_{3-g}R_{g}Si-(Y)ₑ]_{c+1}(C₆F_{4-c})(C₆F₄)_{d}}_{f}SiRₐX_{b} (V)

{[R'-(Y)ₑ][X_{3-g}R_{g}Si-(Y)ₑ](C₆F₃)(C₆F₄)_{d}}_{f}SiRₐX_{b} (VI)

{[(R'(Y)ₑ)_{c+1}(C₆F_{4-c})(C₆F₄)_{d}(X₂₋ₕRₕ₎Si-(Y)ₑ]_{c+1}(C₆F_{4-c})(C₆F₄)_{d}}_{f}SiRₐX_{b} (VII)

mit g = 0, 1, 2 oder 3 und h = 0, 1 oder 2, wobei die übrigen Reste und Indices gleich oder verschieden sind und wie im Falle der allgemeinen der allgemeinen Formel I definiert sind.

Ohne Einschränkung der Allgemeinheit sind im folgenden einige Beispiele für derartige Reste mit dem Index f (für d = 1, 2 oder 3 und g = 2) gemäß der Formeln V und VI dargestellt. Am Silicium-Atom können entweder drei hydrolysierbare Reste X, drei nicht-hydrolysierbare Reste R oder alle möglichen Kombinationen von Resten X und R sitzen.

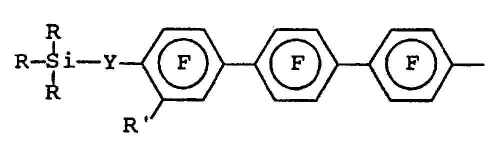

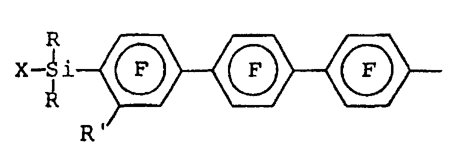

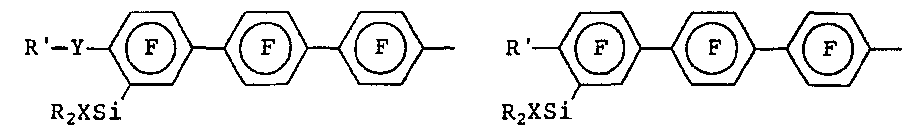

Ohne Einschränkung der Allgemeinheit sind konkrete Beispiele für Reste mit dem Index f gemäß der Formel VII:

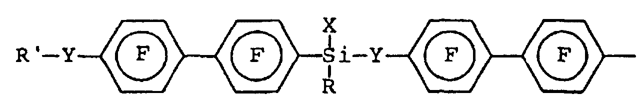

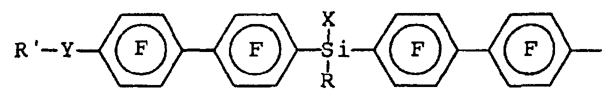

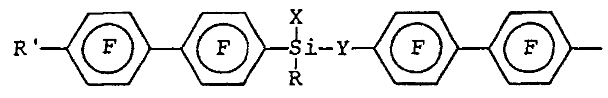

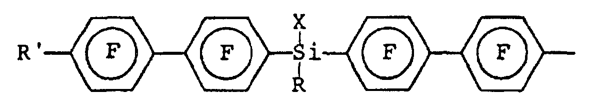

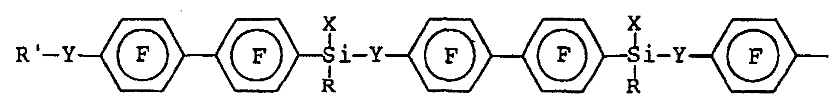

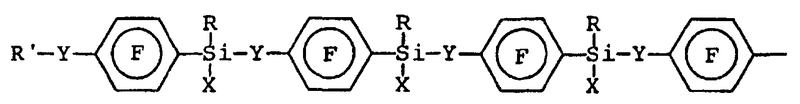

Ohne Einschränkung der Allgemeinheit sind konkrete Ausführungen der erfindunsgemäßen Silane

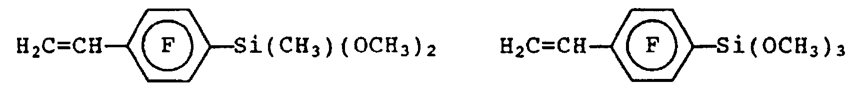

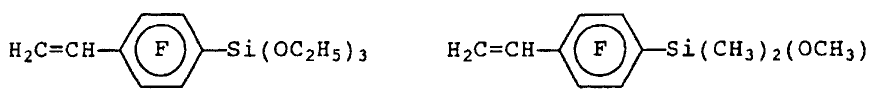

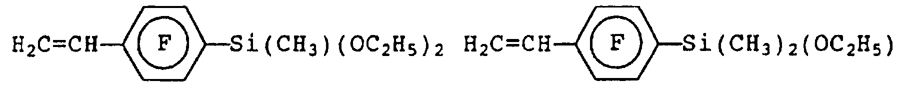

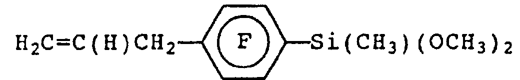

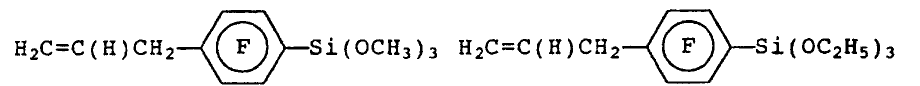

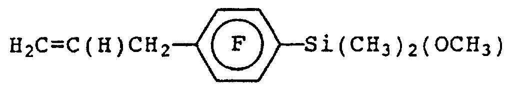

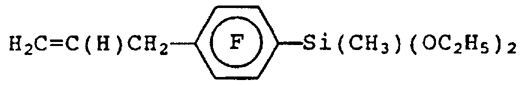

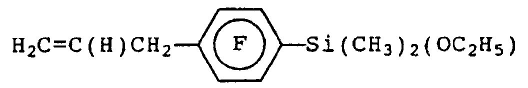

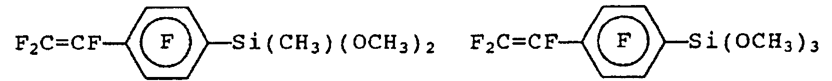

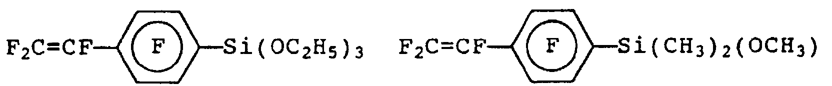

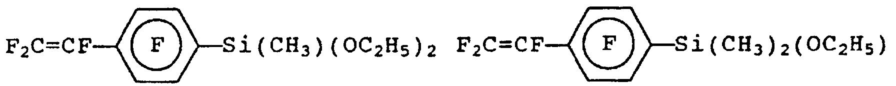

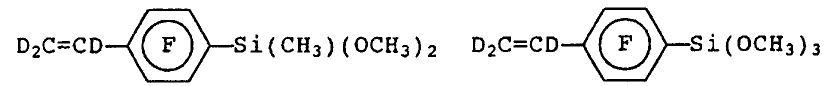

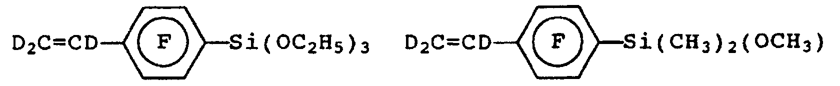

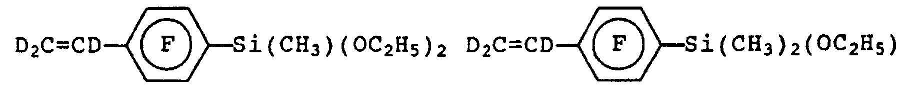

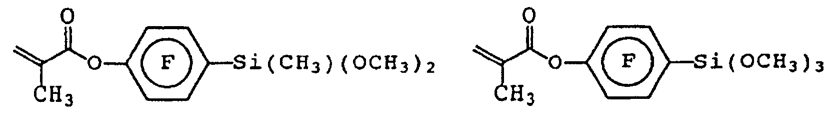

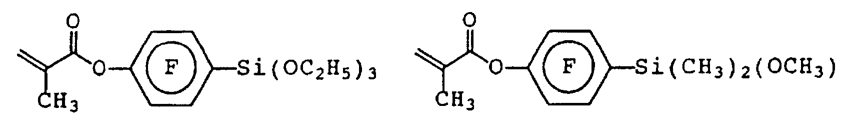

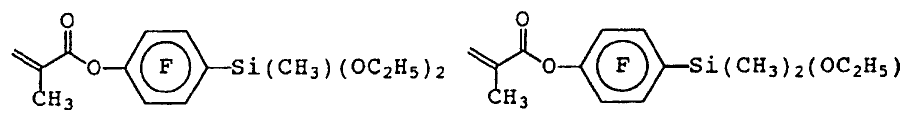

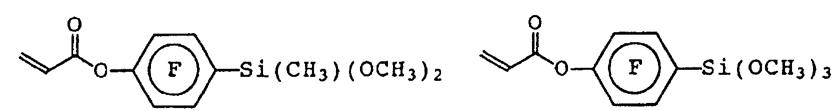

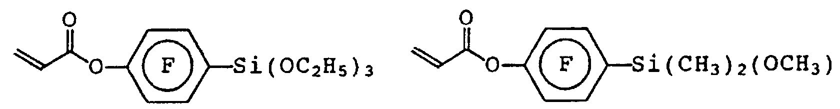

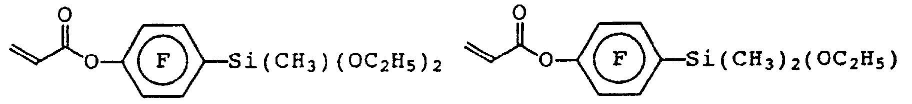

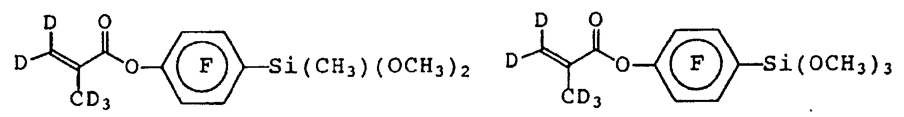

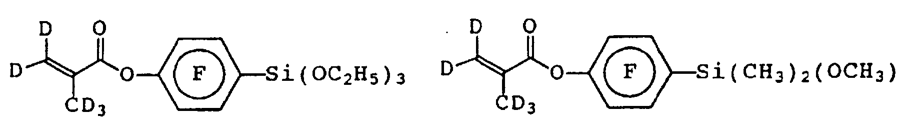

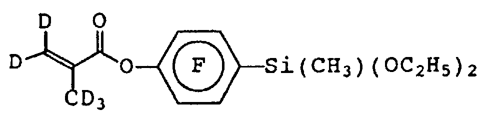

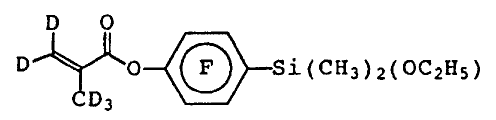

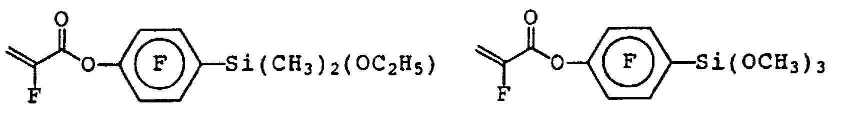

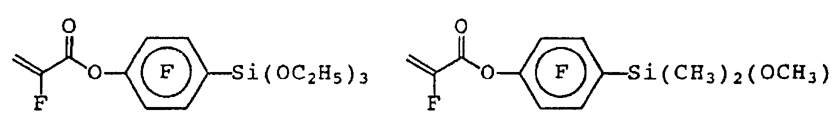

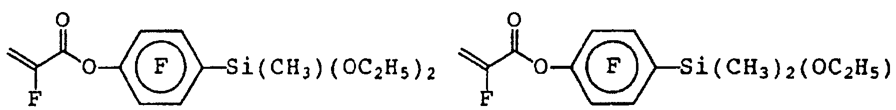

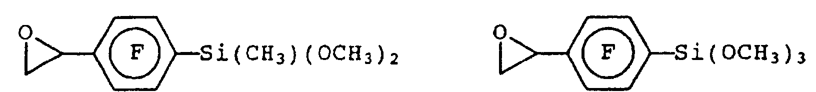

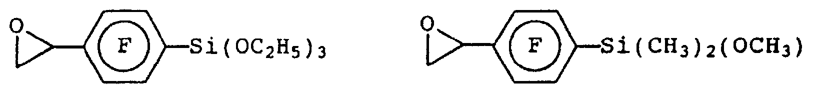

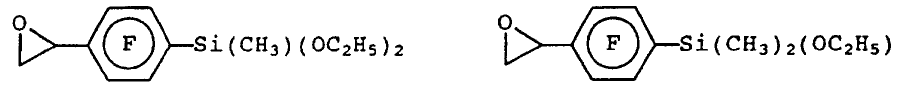

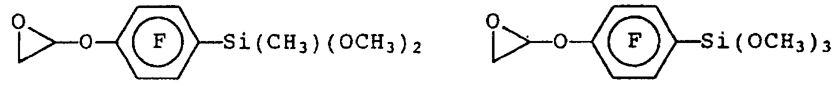

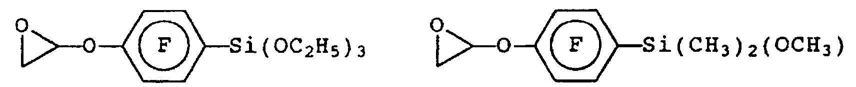

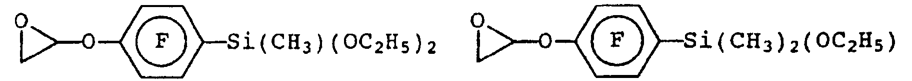

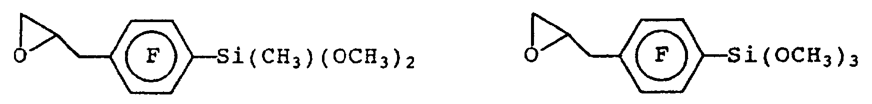

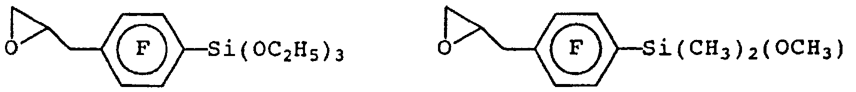

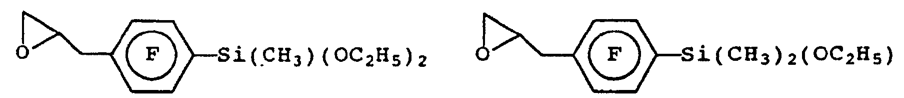

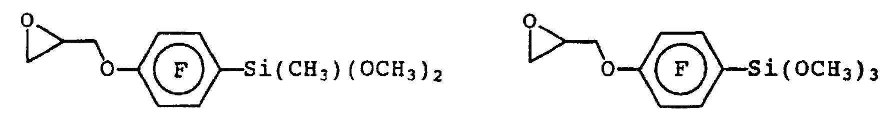

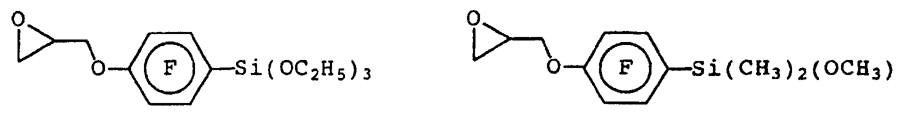

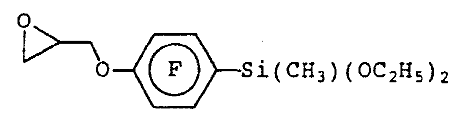

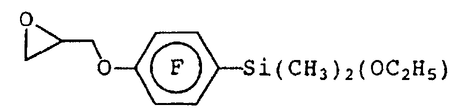

Die Herstellung der erfindungsgemäßen Silane verläuft nach folgendem allgemeinen Reaktionsschema:

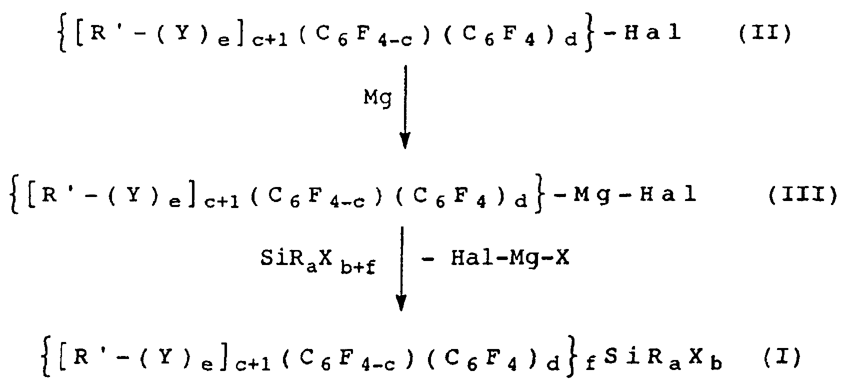

Organische Halogenverbindungen der allgemeinen Formel II werden nach üblichen Methoden mit elementarem Magnesium zu Grignard-Verbindungen der allgemeinen Formel III umgesetzt, und diese, nach üblichen Methoden, an Silane SiRₐX_{b+f} der allgemeinen Formel IV, unter Eliminierung von f Molen Hal-Mg-X, addiert. Die Reste und Indices der allgemeinen Formeln II, III und IV sind wie im Falle der allgemeinen Formel I definiert. Organische Halogenverbindungen der allgemeinen Formel II sind entweder käuflich erwerbbar oder nach üblichen Methoden der präparativen, organischen Chemie erhältlich, wie folgendes Beispiel zeigt.

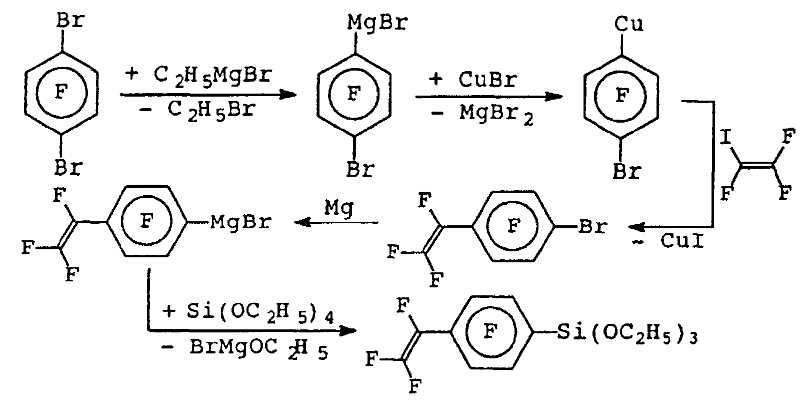

Es ist auch möglich, durch Modifikation und/oder Substitution des Restes R' der erfindungsgemäßen Silane, - nach üblichen Methoden der organischen, präparativen Chemie -, weitere erfindungsgemäße Silane herzustellen.

Die erfindungsgemäßen Silane sind stabile Verbindungen, und können entweder alleine oder zusammen mit anderen hydrolysierbaren, (poly)kondensierbaren und/oder polymerisierbaren und/oder polyaddierbaren Komponenten zu Kieselsäurepolykondensaten oder zu Kieselsäureheteropolykondensaten verarbeitet werden, deren endgültige Härtung dann durch Polymerisation und/oder Polyaddition und/oder Polykondensation der funktionellen Gruppen der erfindungsgemäßen Silane und/oder der zugesetzten Komponenten erfolgt. Die erfindungsgemäßen Silane können aber auch alleine oder zusammen mit anderen hydrolysierbaren, kondensierbaren und/oder polymerisierbaren und/oder polyaddierbaren und/oder polykondensierbaren Komponenten zu Polymerisaten, Polyaddukten oder Polykondensaten verarbeitet werden, die durch anschließende hydrolytische Kondensation verfestigt werden können.

Kieselsäure(hetero)polykondensate, die mit organischen Gruppen modifiziert sind, sowie Verfahren zu deren Herstellung (z.B. ausgehend von hydrolytisch kondensierbaren Organosilanen nach dem Sol-Gel-Prozeß) sind in großer Zahl bekannt. Derartige Kondensate finden, wie eingangs schon erwähnt, für die verschiedensten Zwecke Verwendung, z.B. als Formmassen, als Lacke für Überzüge, etc. Aufgrund der vielfältigen Anwendungsmöglichkeiten dieser Substanzklasse besteht aber auch ein ständiges Bedürfnis nach Modifizierung der bereits bekannten Kondensate, zum einen um dadurch neue Anwendungsgebiet zu erschließen und zum anderen, um deren Eigenschaften für bestimmte Verwendungszwecke noch weiter zu optimieren.

Die erfindungsgemäßen Silane sind im basischen oder sauren Milieu hydrolysier- und kondensierbar. Dadurch ist es möglich, die erfindungsgemäßen Silane durch hydrolytische Kondensation in ein anorganisch-organisches Netzwerk einzubauen. Die erfindungsgemäßen Silane enthalten hydrolysierbare Gruppen X, z.B. Alkoxy-Gruppen, so daß damit ein anorganisches Netzwerk (Si-O-Si-Einheiten) aufgebaut werden kann, während die im Rest R' enthaltenen funktionellen Gruppen, wie z.B. C=C-Doppelbindungen, Spiro-Gruppen oder Oxiran-Ringe, unter Aufbau eines organischen Netzwerkes polymerisiert, polyaddiert oder polykondensiert werden können. Dadurch ist es möglich, organisch modifizierte, hydrolysier- und kondensierbare Silane in Beschichtungs-, Füll-, Klebe- und Dichtungsmassen, in Formkörpern und Einbettmassen nach dem Stand der Technik durch die erfindungsgemäßen Silane zu ersetzen.

Zum Aufbau des anorganischen Netzwerkes werden die erfindungsgemäßen Silane, gegebenenfalls unter Zusatz anderer cokondensierbarer Komponenten hydrolysiert und polykondensiert. Die Polykondensation erfolgt vorzugsweise nach dem Sol-Gel-Verfahren, wie es z.B. in den DE-A1 2758414, 2758415, 3011761, 3826715 und 3835968 beschrieben ist.

Zum Aufbau des organischen Netzwerkes werden die erfindungsgemäßen Silane, gegebenenfalls unter Zusatz anderer copolymerisierbarer, polyaddierbarer oder polykondensierbarer Komponenten, polymerisiert, polyaddiert oder polykondensiert. Die Polymerisation kann z.B. thermisch, redoxinduziert, kovalent-nucleophil und/oder photochemisch unter Einsatz von Methoden erfolgen, wie sie z.B. in den DE-A1 3143820, 3826715 und 3835968 beschrieben sind.

Als weitere polymerisierbare Komponenten können Verbindungen zugesetzt werden, die radikalisch und/oder ionisch polymerisierbar sind. Radikalisch polymerisierbare Verbindungen, die zugesetzt werden können, sind z.B. solche mit C=C-Doppelbindungen, wie z.B. Acrylate oder Methacrylate, wobei die Polymerisation über die C=C-Doppelbindungen erfolgt. Ionisch polymerisierbare Verbindungen, die zugesetzt werden können, enthalten z.B. Ringsysteme, die kationisch ringöffnend polymerisierbar sind, wie z.B. Spiroorthoester, Spiroorthocarbonate, bicyclische Spiroorthoester, Mono- oder Oligoepoxide oder Spiro-Silane, wie sie aus der DE 4125201 C1 bekannt sind. Es können aber auch Verbindungen zugesetzt werden, die sowohl ionisch als auch radikalisch polymerisierbar sind, wie z.B. Methacryloyl-Spiroorthoester. Diese sind radikalisch über die C=C-Doppelbindung und kationisch unter Ringöffnung polymerisierbar. Die Herstellung dieser Systeme ist z.B. im Journal f. prakt. Chemie, Band 330, Heft2, 1988, S. 316-318, beschrieben. Desweiteren können die erfindungsgemäßen Silane in Systemen eingesetzt werden, wie sie z.B. in der DE 4405261 beschrieben sind.

Ferner ist es möglich, andere bekannte, silan-gebundene cyclische Systeme zuzusetzen, die mit einpolymerisiert werden können. Solche Systeme sind z.B. solche, die Epoxide enthalten. Solche Systeme sind bei der Herstellung der Spiro-Silane der DE 4125201 C1 beschrieben.

Die erfindungsgemäßen Silane stellen zum Teil hoch reaktive Systeme dar, die zu Poly(hetero)kondensaten führen, die z.B. bei UV-Bestrahlung innerhalb kürzester Zeit zu mechanisch stabilen Überzügen oder Form- bzw. Füllkörpern führen. Die erfindungsgemäßen Silane sind über einfache Reaktionen herstellbar und können durch geeignete Auswahl der Ausgangsverbindungen eine variierbare Anzahl reaktiver Gruppen unterschiedlicher Funktionalität aufweisen.

Bei Anwesenheit von zwei oder mehr C=C-Doppelbindungen im Rest R' ist die Ausbildung eines dreidimensionalen, organischen Netzwerkes möglich. Über den Abstand zwischen dem Si-Atom und dem Rest R', d.h. über die Kettenlänge der Phenylen-Einheiten, und über die Anwesenheit weiterer funktioneller Gruppen, können die mechanischen Eigenschaften (z.B. Flexibilität) und die physikalisch-chemischen Eigenschaften (Adsorption, Brechzahl, Haftung etc.) der Poly(hetero)kondensate beeinflußt werden. Durch die Ausbildung eines anorganischen Netzwerkes können je nach Art und Anzahl der hydrolysierbaren Gruppen (z.B. Alkoxy-Gruppen) silicon- oder glasartige Eigenschaften der Poly(hetero)kondensate eingestellt werden.

Die erfindungsgemäßen Silane besitzen relativ hohe Molekulargewichte und dementsprechend eine verminderte Flüchtigkeit z.B. gegenüber reinen (Meth)Acrylat-Monomeren, so daß die toxische Gefährdung während der Verarbeitung und Applikation geringer ist. Bei der anorganischen und/oder organischen Vernetzung bilden sich Polysiloxane mit nochmals erniedrigter Flüchtigkeit, die damit das Toxizitätsproblem der Acrylatkomponenten völlig beheben.

Berücksichtigt man dann noch die Variationsmöglichkeiten der cokondensierbaren und copolymerisierbaren und polyaddierbaren Komponenten, so wird offenbar, daß über die erfindungsgemäßen Silane Kieselsäure(hetero)polykondensate zur Verfügung gestellt werden, die in vielfältiger Weise an vorgegebene Einsatzgebiete angepaßt werden können, und die deshalb auf allen Gebieten, auf denen bereits bisher Kieselsäure(hetero)-polykondensate eingesetzt werden, Verwendung finden können, aber auch neue Verwendungsmöglichkeiten eröffnen, z.B. auf dem Gebiet der Optik, der Elektronik, der Medizin, der Optoelektronik und der Verpackungsmittel für Lebensmittel etc.

Die erfindungsgemäßen Silane können entweder als solche verwendet werden oder in Zusammensetzungen, die zusätzlich an den Verwendungszweck angepaßte Additive enthalten, z.B. übliche Lackadditive, Lösungsmittel, Füllstoffe, Photoinitiatoren, thermische Initiatoren, Verlaufsmittel und Pigmente. Die erfindungsgemäßen Silane oder die silanhaltigen Zusammensetzungen eignen sich z.B. zur Herstellung von Beschichtungs-, Füllstoff- oder Bulkmaterialien, von Klebstoffen und Spritzgußmassen, von Fasern, Partikeln, Folien, Haftvermittlern, von Abformmassen und von Einbettmaterialien. Beschichtungen und Formkörper aus den erfindungsgemäßen Silanen haben den Vorteil, daß sie photochemisch strukturierbar sind. Spezielle Anwendungsgebiet sind z.B. die Beschichtung von Substraten aus Metall, Kunststoff, Papier, Keramik etc. durch Tauchen, Gießen, Streichen, Spritzen, elektrostatisches Spritzen, Elektrotauchlackierung etc., der Einsatz für optische, optoelektrische oder elektronische Komponenten, die Herstellung von Füllstoffen, die Herstellung von kratzfesten, abriebfesten Korrosionsschutzbeschichtungen, die Herstellung von Formkörpern, z.B. durch Spritzguß, Formgießen, Pressen, Rapid-Prototyping oder Extrusion, und die Herstellung von Compositen, z.B. mit Fasern, Füllstoffen oder Geweben.

Neben den erfindungsgemäßen Silanen der Formel I können noch weitere hydrolytisch kondensierbare Verbindungen des Siliciums, des Bors, des Aluminiums, des Phosphors, des Zinns, des Bleis, der Übergangsmetalle, der Lanthaniden oder Actiniden eingesetzt werden. Diese Verbindungen können entweder als solche oder bereits in vorkondensierter Form zur Herstellung der Polykondensate herangezogen werden. Bevorzugt ist es, wenn mindestens 10 Mol-%, insbesondere mindestens 80 Mol-% und speziell mindestens 90 Mol-%, auf der Basis momomerer Verbindungen, der zu Herstellung der Kieselsäure(hetero)polykondensate herangezogenen Ausgangsmaterialien Silicium-Verbindungen sind.

Ebenso ist es bevorzugt, wenn den Kieselsäure(hetero)polykondensaten mindestens 5 Mol-%, z.B. 25 bis 100 Mol-%, insbesondere 50 bis 100 Mol-% und speziell 75 bis 100 Mol-%, jeweils auf der Basis monomerer Verbindungen, an einem oder mehreren der erfindungsgemäßen Silane zugrundeliegen.

Die erfindungsgemäßen Silane müssen für die Weiterverarbeitung zu den Poly(hetero)kondensaten nicht unbedingt isoliert werden. Es ist auch möglich, in einem Eintopf-Verfahren, diese Silane zunächst herzustellen und dann - gegebenenfalls nach Zusatz weiterer hydrolysierbarer Verbindungen - hydrolytisch zu kondensieren.

Unter den von Silanen der allgemeinen Formel I verschiedenen, hydrolytisch kondensierbaren Silicium-Verbindungen, die gegebenenfalls eingesetzt werden können, sind solche der allgemeinen Formel VIII besonders bevorzugt,

Rₐ(R''Z')_{b}SiX_{4-(a+b)} (VIII)

in der die Reste R,R'', X und Z' gleich oder verschieden sind und folgende Bedeutung haben:
- R =: Alkyl, Alkenyl, Aryl, Alkylaryl oder Arylalkyl,
- R" =: Alkylen oder Alkenylen, wobei diese Reste durch Sauerstoff- oder Schwefelatome oder -NH-Gruppen unterbrochen sein können,
- X =: Wasserstoff, Halogen, Hydroxy, Alkoxy, Acyloxy, Alkylcarbonyl, Alkoxycarbonyl oder NR'₂, mit R' = Wasserstoff, Alkyl oder Aryl,
- Z' =: Halogen oder eine gegebenenfalls substituierte Amino-, Amid-, Aldehyd-, Alkylcarbonyl-, Carboxy-, Mercapto-, Cyano-, Alkoxy-, Alkoxycarbonyl-, Sulfonsäure-, Phosphorsäure-, Acryloxy-, Methacryloxy-, Epoxy- oder vinyl-Gruppe,
- a =: 0, 1, 2, oder 3,
- b =: 0, 1, 2, oder 3, mit a+b = 1, 2 oder 3.

Solche Silane sind z.B. in der DE 34 07 087 C2 beschrieben.

Spezielle Beispiele für hydrolytisch kondensierbare Silane der allgemeinen Formel VIII sind:
CH₃-Si-Cl₃, CH₃-Si-(OC₂H₅)₃, C₂H₅-Si-Cl₃, C₂H₅-Si-(OC₂H₅)₃, CH₂=CH-Si-(OC₂H₅)₃, CH₂=CH-Si-(OC₂H₄OCH₃)₃, (CH₃)₂-Si-Cl₂, CH₂=CH-Si-(OOCCH₃)₃, (CH₃)₂-Si-(OC₂H₅)₂, (C₂H₅)₃-Si-Cl, (C₂H₅)₂-Si-(OC₂H₅)₂, (CH₃)₂(CH₂=CH)-Si-Cl₂, (CH₃)₃-Si-Cl, (t-C₄H₉)(CH₃)₂-Si-Cl, (CH₃O)₃-Si-C₃H₆-NH-C₂H₄-NH-C₂H₄-NH₂, (CH₃O)₃-Si-C₃H₆-SH, (CH₃O)₃-Si-C₃H₆-NH-C₂H₄-NH₂, (CH₃O)₃-Si-C₃H₆-Cl, (CH₃O)₃-Si-C₃H₆-O-C(O)-C(CH₃)=CH₂, (CH₃)₂(CH₂=CH-CH₂)-Si-Cl, (C₂H₅O)₃-Si-C₃H₆-NH₂, (C₂H₅O)₃-Si-C₃H₆-CN,

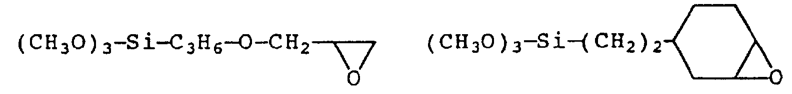

Unter den von Silanen der allgemeinen Formel I verschiedenen, hydrolytisch kondensierbaren Silicium-Verbindungen, die gegebenenfalls noch eingesetzt werden können, sind solche der allgemeinen Formel IX ebenfalls bevorzugt,

{XₙRₖSi[(R²A)₁]₄₋₍ₙ₊ₖ₎}ₓB (IX)

in der die Reste A, R, R² und X gleich oder verschieden sind und folgende Bedeutung haben.
- A =: O, S, PR', POR', NHC(O)O oder NHC(O)NR', mit R' = Wasserstoff, Alkyl oder Aryl,
- B =: geradkettiger oder verzweigter organischer Rest, der sich von einer Verbindung B' mit mindestens einer (für 1 = 1 und A = NHC(O)O oder NHC(O)NR') bzw. mindestens zwei C=C-Doppelbindungen und 5 bis 50 Kohlenstoff-Atomen ableitet, mit R'= Wasserstoff, Alkyl oder Aryl,
- R =: Alkyl, Alkenyl, Aryl, Alkylaryl oder Arylalkyl,
- R² =: Alkylen, Arylen oder Alkylenarylen,
- X =: Wasserstoff, Halogen, Hydroxy, Alkoxy, Acyloxy, Alkylcarbonyl, Alkoxycarbonyl oder NR'₂, mit R' = Wasserstoff, Alkyl oder Aryl,
- n =: 1, 2 oder 3,
- k =: 0, 1 oder 2,
- l =: 0 oder 1,
- x =: eine ganze Zahl, deren Maximalwert der Anzahl von Doppelbindungen in der Verbindung B' minus 1 entspricht, bzw. gleich der Anzahl von Doppelbindungen in der Verbindung B' ist, wenn l = 1 und A für NHC(O)O oder NHC(O)NR' steht.

Solche Silane sind in der DE 40 11 044 und in der EP 91 105 355 beschrieben.

Unter den von Silanen der allgemeinen Formel I verschiedenen, hydrolytisch kondensierbaren Silicium-Verbindungen, die gegebenenfalls noch eingesetzt werden können, sind solche der allgemeinen Formel X ebenfalls besonders bevorzugt,

Yₙ Si Xₘ R₄₋₍ₙ₊ₘ₎ (X)

in der die Reste X, Y und R gleich oder verschieden sind und folgende Bedeutung haben:
- R =: Alkyl, Alkenyl, Aryl, Alkylaryl oder Arylalkyl,
- X =: Wasserstoff, Halogen, Hydroxy, Alkoxy, Acyloxy, Alkylcarbonyl, Alkoxycarbonyl oder NR'₂, mit R' = Wasserstoff, Alkyl oder Aryl,
- Y =: ein Substituent, der einen substituierten oder unsubstituierten 1,4,6-Trioxaspiro-[4,4]-nonan-Rest enthält,
- n =: 1, 2 oder 3,
- m =: 1, 2 oder 3, mit n+m ≤ 4.

Diese Spiro-Silane sind über die Reste X hydrolysierbar und über die Reste Y polymerisierbar und sie sind in der DE 4125201 C1 ausführlichst beschrieben.

Unter den gegebenenfalls eingesetzten hydrolysierbaren Aluminium-Verbindungen sind diejenigen besonders bevorzugt, die die allgemeine Formel

AlR°₃

aufweisen, in der die Reste R°, die gleich oder verschieden sein können, ausgewählt sind aus Halogen, Alkoxy, Alkoxycarbonyl und Hydroxy. Hinsichtlich der näheren (bevorzugten) Definitionen dieser Reste kann auf die Ausführungen im Zusammenhang mit den geeigneten hydrolysierbaren Silicium-Verbindungen verwiesen werden. Die soeben genannten Gruppen können auch ganz oder teilweise durch Chelatliganden (z.B. Acetylaceton oder Acetessigsäureester, Essigsäure) ersetzt sein.

Besonders bevorzugte Aluminium-Verbindungen sind Aluminiumalkoxide und -halogenide. In diesem Zusammenhang können als konkrete Beispiele genannt werden
Al(OCH₃)₃, Al(OC₂H₅)₃, Al(O-n-C₃H₇)₃, Al(O-i-C₃H₇)₃, Al(OC₄H₉)₃, Al(O-i-C₄H₉)₃, Al(O-s-C₄H₉)₃, AlCl₃, AlCl(OH)₂.

Bei Raumtemperatur flüssige Verbindungen, wie z.B. Aluminiumsek-butylat und Aluminium-isopropylat, werden besonders bevorzugt.

Geeignete hydrolysierbare Titan- oder Zirkonium-Verbindungen, die gegebenenfalls eingesetzt werden können, sind solche der allgemeinen Formel

M X_{y}R_{z},

in der M Ti oder Zr bedeutet, y eine ganze Zahl von 1 bis 4 ist, insbesondere 2 bis 4, z für 0, 1, 2 oder 3 steht, vorzugsweise für 0, 1 oder 2, und X und R wie im Falle der allgemeinen Formel I definiert sind. Dies gilt auch für die bevorzugten Bedeutungen. Besonders bevorzugt handelt es sich bei diesen Verbindungen um solche, in denen y gleich 4 ist.

Wie im Falle der obigen Al-Verbindungen können auch komplexierte Ti- oder Zr-Verbindungen eingesetzt werden. zusätzliche bevorzugte Komplexbildner sind hier Acrylsäure und Methacrylsäure, wobei erfindungsgemäße Silane, die Acryl- bzw. Methacryl-Gruppen aufweisen, ebenfalls zur Komplexierung verwendet werden können. In diesem Fall besteht der große Vorteil der erfindungsgemäßen Silane darin, daß zur Komplexierung von Ti- und/oder Zr-Verbindungen keine zusätzlichen Komplexierungsmittel eingesetzt werden müssen.

Konkrete Beispiele für einsetzbare Zr- und Ti-Verbindungen sind die folgenden:

TiCl₄, Ti(OC₂H₅)₄, Ti(OC₃H₇)₄, Ti(O-i-C₃H₇)₄, Ti(OC₄H₉)₄, Ti(2-ethylhexoxy)₄, ZrCl₄, Zr(OC₂H₅)₄, Zr(OC₃H₇)₄, Zr(O-i-C₃H₇)₄, Zr(OC₄H₉)₄, Zr(2-ethylhexoxy)₄, ZrOCl₂

Weitere hydrolysierbare Verbindungen, die zur Herstellung der Polyheterokondensate eingesetzt werden können, sind z.B. Bortrihalogenide und Borsäureester, wie z.B. BCl₃, B(OCH₃)₃ und B(OC₂H₅)₃, Zinntetrahalogenide und Zinntetraalkoxide, wie z.B. SnCl₄ und Sn(OCH₃)₄, und Vanadyl-Verbindungen, wie z.B. VOCl₃ und VO(OCH₃)₃.

Wie bereits erwähnt, kann die Herstellung der Poly(hetero)-kondensate in auf diesem Gebiet üblicher Art und Weise erfolgen. Werden praktisch ausschließlich Silicium-Verbindungen eingesetzt, kann die hydrolytische Kondensation in den meisten Fällen dadurch erfolgen, daß man den zu hydrolysierenden Silicium-Verbindungen, die entweder als solche oder gelöst in einem geeigneten Lösungsmittel vorliegen, das erforderliche Wasser bei Raumtemperatur oder unter leichter Kühlung direkt zugibt (vorzugsweise unter Rühren und in Anwesenheit eines Hydrolyse- und Kondensationskatalysators) und die resultierende Mischung daraufhin einige Zeit (ein bis mehrere Stunden) rührt.

Bei Anwesenheit reaktiver Verbindungen von Al, Ti oder Zr empfielt sich in der Regel eine stufenweise Zugabe des Wassers. Unabhängig von der Reaktivität der anwesenden Verbindungen erfolgt die Hydrolyse in der Regel bei Temperaturen zwischen -20 und 130 °C, vorzugsweise zwischen 0 und 30 °C bzw. dem Siedepunkt des gegebenenfalls eingesetzten Lösungsmittels. Wie bereits angedeutet, hängt die beste Art und Weise der Zugabe von Wasser vor allem von der Reaktivität der eingestzten Ausgangsverbindungen ab. So kann man z.B. die gelösten Ausgangsverbindungen langsam zu einem Überschuß an Wasser tropfen oder man gibt Wasser in einer Portion oder portionsweise den gegebenenfalls gelösten Ausgangsverbindungen zu. Es kann auch nützlich sein, das Wasser nicht als solches zuzugeben, sondern mit Hilfe von wasserhaltigen organischen oder anorganischen Systemen in das Reaktionssystem einzutragen. Als besonders geeignet hat sich in vielen Fällen die Eintragung der Wassermenge in das Reaktionsgemisch mit Hilfe von feuchtigkeitsbeladenen Adsorbentien, z.B. von Molekularsieben, und von wasserhaltigen, organischen Lösungsmitteln, z.B. von 80 %-igem Ethanol, erwiesen. Die Wasserzugabe kann aber auch über eine chemische Reaktion erfolgen, bei der Wasser im Laufe der Reaktion freigesetzt wird. Beispiele hierfür sind Veresterungen.

Wenn ein Lösungsmittel verwendet wird, kommen neben den niederen aliphatischen Alkoholen (z.B. Ethanol oder i-Propanol) auch Ketone, vorzugsweise niedere Dialkylketone, wie Aceton oder Methylisobutylketon, Ether, vorzugsweise niedere Dialkylether wie Diethylether oder Dibutylether, THF, Amide, Ester, insbesondere Essigsäureethylester, Dimethylformamid, Amine, insbesondere Triethylamin, und deren Gemische in Frage.

Werden Spiro-Silane zur Herstellung der Poly(hetero)kondensate eingesetzt, so wird die Hydrolyse bevorzugt in einem bzgl. der Spiro-Silane basischen Milieu durchgeführt. Dies wird entweder durch ein basisches Lösungsmittel, wie z.B. durch Triethylamin, erzeugt, oder durch Zugabe von basichen Hydrolyse- und Kondensationskatalysatoren, wie z.B. von NH₃, NaOH, KOH, Methylimidazol, etc.

Die Ausgangsverbindungen müssen nicht notwendigerweise bereits alle zu Beginn der Hydrolyse (Polykondensation) vorhanden sein, sondern in bestimmten Fällen kann es sich sogar als vorteilhaft erweisen, wenn nur ein Teil dieser Verbindungen zunächst mit Wasser in Kontakt gebracht wird und später die restlichen Verbindungen zugegeben werden.

Um insbesondere bei Verwendung von von Silicium-Verbindungen verschiedenen hydrolysierbaren Verbindungen Ausfällungen während der Hydrolyse und der Polykondensation so weit wie möglich zu vermeiden, kann die Wasserzugabe in mehreren Stufen, z.B. in drei Stufen, durchgeführt werden. Dabei kann in der ersten Stufe z.B. ein Zehntel bis ein Zwangzigstel der zur Hydrolyse benötigten Wassermenge zugegeben werden. Nach kurzem Rühren kann die Zugabe von einem Fünftel bis zu einem Zehntel der erforderlichen Wassermenge erfolgen und nach weiterem kurzen Rühren kann schließlich der Rest zugegeben werden.

Die Kondensationszeit richtet sich nach den jeweiligen Ausgangskomponenten und deren Mengenanteilen, dem gegebenfalls verwendeten Katalysator, der Reaktionstemperatur, etc. Im allgemeinen erfolgt die Polykondensation bei Normaldruck, sie kann jedoch auch bei erhöhtem oder bei verringertem Druck durchgeführt werden.

Das so erhaltene Poly(hetero)kondensat kann entweder als solches oder nach teilweiser oder nahezu vollständiger Entfernung des verwendeten Lösungsmittels weiterverarbeitet werden. In einigen Fällen kann es sich als vorteilhaft erweisen, in dem nach der Polykondensation erhaltenen Produkt das überschüssige Wasser und das gebildete und gegebenenfalls zusätzlich eingesetzte Lösungsmittel durch ein anderes Lösungsmittel zu ersetzen, um das Poly(hetero)kondensat zu stabilisieren. Zu diesem Zweck kann die Reaktionsmischung z.B. im Vakuum bei leicht erhöhter Temperatur so weit eingedickt werden, daß sie noch problemlos mit einem anderen Lösungsmittel aufgenommen werden kann.

Sollen diese Poly(hetero)kondensate als Lacke für die Beschichtung (z.B. von Kunststoffen wie etwa PVC, PC, PMMA, PE, PS etc., von Glas, Papier, Holz, Keramik, Metall usw.) eingesetzt werden, so können diesen spätestens vor der Verwendung gegebenenfalls noch übliche Lackadditive zugegeben werden, wie z.B. Färbemittel (Pigmente oder Farbstoffe), Füllstoffe, Oxidationsinhibitoren, Flammschutzmittel, Verlaufsmittel, UV-Absorber, Stabilisatoren oder dergleichen. Auch Zusätze zur Erhöhung der Leitfähigkeit (z.B. Graphit-Pulver, Silber-Pulver etc.) verdienen in diesem Zusammenhang Erwähnung. Im Falle der Verwendung als Formmasse kommt insbesondere die Zugabe von anorganischen und/oder organischen Füllstoffen in Frage, wie z.B. organische und anorganische Partikel, (Glas)-Fasern, Mineralien etc.

Die endgültige Härtung der Poly(hetero)kondensate erfolgt, gegebenenfalls nach Zugabe geeigneter Initiatoren, thermisch, redox-induziert, kovalent-nucleophil oder photochemisch, wobei auch mehrere Härtungsmechanismen parallel und/oder nacheinander ablaufen können. Dabei werden im Zuge der Polymerisation, Polyaddition oder Polykondensation z.B. C=C-Doppelbindungen, Spiro-Gruppen oder Oxiran-Ringe verknüpft, und es wird das organische Netzwerk aufgebaut. Aufgrund der relativ hohen Molekulargewichte der erfindungsgemäßen Silane erfahren diese bei der Härtung nur eine geringe Volumenschrumpfung.

Es ist auch möglich, dem Poly(hetero)kondensat vor der endgültigen Härtung, also z.B. vor der Polymerisation weitere ionisch und/oder radikalisch polymerisierbare Komponenten zuzusetzen. Radikalisch polymerisierbare Verbindungen, die zugesetzt werden können, sind z.B. solche mit C=C-Doppelbindungen, wie etwa Acrylate oder Methacrylate, wobei die Polymerisation über die C=C-Doppelbindungen verläuft. Ionisch polymerisierbare Verbindungen, die zugesetzt werden können, enthalten z.B. Ringsysteme, die kationisch, ringöffnend polymerisierbar sind, wie etwa Spiroorthoester, Spiroorthocarbonate, bicyclische Spiroorthoester, Mono- oder oligoepoxide oder Spirosilane der allgemeinen Formel X. Es können aber auch Verbindungen zugesetzt werden, die sowohl kationisch als auch radikalisch polymerisierbar sind, wie z.B. Methacryloyl-Spiroorthoester. Diese sind radikalisch über die C=C-Doppelbindung und kationisch unter Ringöffnung polymerisierbar. Diese Systeme sind z.B. im Journal f. prakt. Chemie, Band 330, Heft2, 1988, S. 316-318, oder im Journal of Polymer Science: Part C: Polymer Letters, Vol. 26, S. 517-520 (1988) beschrieben.

Erfolgt die Härtung des Poly(hetero)kondensates photochemisch, so werden diesem Photoinitiatoren zugesetzt, bei thermischer Härtung thermische Initiatoren und bei redox-induzierter Härtung Starter-Aktivator-Systeme.

Der Initiator kann in üblichen Mengen zugegeben werden. So kann z.B. einer Mischung, die 30 bis 50 Gew.-% Feststoff (Polykondensat) enthält, Initiatoren in einer Menge von z.B. 0.5 bis 5 Gew.-%, insbesondere von 1 bis 3 Gew.-%, bezogen auf die Mischung zugesetzt, werden.

Werden zur Herstellung der Poly(hetero)kondensate neben den erfindungsgemäßen Silanen weitere Komponenten eingesetzt, die reaktive Doppelbindungen enthalten, wie z.B. Silane gemäß der allgemeinen Formel IX, so kann über diese Doppelbindungen ebenfalls eine Polymerisation ablaufen, die thermisch und/oder photochemisch und/oder kovalent-nucleophil und/oder redox initiiert sein kann.

Als Photoinitiatoren können z.B. die im Handel erhältlichen eingesetzt werden. Beispiel hierfür sind Irgacure 184 (1-Hydroxycyclohexylphenylketon), Irgacure 500 (1-Hydroxycyclohexylphenylketon/Benzophenon), und andere von Ciba-Geigy erhältliche Photoinitiatoren vom Irgacure-Typ; Darocure 1173, 1116, 1398, 1174 und 1020 (erhältlich von der Firma Merck), Benzophenon, 2-Chlorthioxanthon, 2-Methylthioxanthon, 2-Isopropylthioxanthon, Benzoin, 4.4'-Dimethoxybenzoin etc. Erfolgt die Härtung mit sichtbaren Licht, wie z.B. im Dentalbereich, so kann als Initiator z.B. Campherchionon eingesetzt werden.

Als thermische Initiatoren kommen insbesondere organische Peroxide in Form von Diacylperoxiden, Peroxydicarbonaten, Alkylperestern, Dialkylperoxiden, Perketalen, Ketonperoxiden und Alkylhydroperoxiden in Frage. Konkrete und bevorzugte Beispiele für thermische Initiatoren sind Dibenzoylperoxid, t-Butylperbenzoat und Azobisisobutyronitril.

Als Starter/Aktivator-Systeme können hierfür übliche eingesetzt werden, wie z.B. aromatische Amine (z.B. N,N-Bis-(2-hydroxy-ethyl)-p-toluidin) als Aktivatoren oder als Starter z.B. Dibenzoylperoxid, wobei über deren Konzatration bzw. deren Konzentrationsverhältnis die Härtungszeit entsprechend dem jeweiligen Anwendungsfall eingestellt werden kann. Weitere Amine sind z.B. der DE 4310733 zu entnehmen.

Bei kovalent-nucleophiler Härtung werden als Initiatoren z.B. Verbindungen mit mindestens einer Amino-Gruppe zugesetzt. Geeignete Amine sind z.B. der DE 4405261 zu entnehmen.

Ein mit einem Initiator versehener Lack (Poly(hetero)kondensat) auf der Basis der erfindungsgemäßen Silane kann dann für Beschichtungen von Substraten eingesetzt werden. Für diese Beschichtung können übliche Beschichtungsverfahren angewendet werden, z.B. Tauchen, Fluten, Gießen, Schleudern, Walzen, Spritzen, Aufstreichen, elektrostatisches Spritzen und Elektrotauchlackierung. Erwähnt werden soll hier noch, daß der Lack nicht notwendigerweise lösungsmittelhaltig sein muß. Insbesondere bei Verwendung von Ausgangssubstanzen (Silanen) mit zwei Alkoxy-Gruppen am Si-Atom kann auch ohne Zusatz von Lösungsmitteln gearbeitet werden.

Vor der Härtung läßt man vorzugsweise den aufgetragenen Lack abtrocknen. Danach kann er, abhängig von der Art des Initiators, redox-induziert, thermisch oder photochemisch in an sich bekannter Weise gehärtet werden. Selbstverständlich sind auch Kombinationen von Aushärtungsmethoden möglich.

Erfolgt die Härtung des aufgetragenen Lackes durch Bestrahlen kann es sich von Vorteil erweisen, nach der Strahlungshärtung eine thermische Härtung durchzuführen, insbesondere um noch vorhandenes Lösungsmittel zu entfernen oder um noch weitere reaktive Gruppen in die Härtung miteinzubeziehen.

Obwohl in den Poly(hetero)kondensaten auf der Basis der erfindungsgemäßen Silane bereits polymerisierbare Gruppen vorhanden sein können, kann es sich in bestimmten Fällen als vorteilhaft erweisen, diesen Kondensaten vor oder bei ihrer Weiterverarbeitung (Härtung) noch weitere Verbindungen (vorzugsweise rein organischer Natur) mit z.B. ungesättigten Gruppen zuzugeben. Bevorzugte Beispiele für derartige Verbindungen sind Acrylsäure und Methacrylsäure sowie davon abgeleitete Verbindungen, insbesondere Ester von vorzugsweise einwertigen Alkoholen (z.B. C₁₋₄-Alkanolen), (Meth)Acrylnitril, Styrol und Mischungen derselben. Im Fall der Verwendung der Poly(hetero)kondensate zur Herstellung von Beschichtungslacken können derartige Verbindungen gleichzeitig als Lösungs- bzw. Verdünnungsmittel wirken.

Die Herstellung von Formkörpern bzw. Formmassen aus Poly(hetero)kondensaten auf der Basis der erfindungsgemäßen Silane kann mit jeder auf diesem Gebiet gebräuchlichen Methode erfolgen, z.B. durch Pressen, Spritzguß, Formgießen, Extrusion etc. Auch zur Herstellung von Kompositmaterialien (z.B. mit Glasfaserverstärkung) sind die Poly(hetero)kondensate auf der Basis der erfindungsgemäßen Silane geeignet.

Eine weitere Anwendungsmöglichkeit finden die erfindungsgemäßen Silane bei der Herstellung von hydrolytisch kondensierbaren Polymerisaten, Polyaddukten oder Polykondensaten. Dazu werden die erfindungsgemäßen Silane alleine oder zusammen mit anderen radikalisch und/oder ionisch polymerisierbaren, polyaddierbaren oder polykondensierbaren Komponenten polymerisiert, polyaddiert oder polykondensiert, wobei die endgültige Härtung dann durch hydrolytische Kondensation über die hydrolysierbaren Gruppen der erfindungsgemäßen Silane und eventuell weiterer, hydrolysierbarer Komponenten erfolgt. In diesem Fall wird zuerst durch Polymerisation das organische Netzwerk aufgebaut und dann durch hydrolytische Kondensation das anorganische.

Die Herstellung der Polymerisate erfolgt durch radikalische und/oder ionische Polymerisation einer oder mehrerer C=C-Doppelbindungen-haltiger Verbindungen und gegebenenfalls anderer, radikalisch und/oder ionisch polymerisierbarer Verbindungen redox-induziert und/oder kovalent-nucleophil und/oder durch Einwirkung von Wärme und/oder von elektromagnetischer Strahlung, gegebenenfalls in Anwesenheit eines oder mehrerer Initiatoren und/oder eines Lösungsmittels, und ist dadurch gekennzeichnet, daß 5 bis 100 Molprozent, auf der Basis monomerer Verbindungen, der C=C-Doppelbindungen-haltiger Verbindungen aus den erfindungsgemäßen Silanen der allgemeinen Formel I ausgewählt werden.

Es ist aber auch möglich, den erfindungsgemäßen Silanen vor der Polymerisation weitere ionisch und/oder radikalisch polymerisierbare Komponenten zuzusetzen. Radikalisch polymerisierbare Verbindungen, die zugesetzt werden können, sind z.B. solche mit C=C-Doppelbindungen, wie etwa Acrylate oder Methacrylate, wobei die Polymerisation über die C=C-Doppelbindungen erfolgt. Ionisch polymerisierbare Verbindungen, die zugesetzt werden können, enthalten z.B. Ringsysteme, die kationisch, ringöffnend polymerisierbar sind, wie etwa Spiroorthoester, Spiroorthocarbonate, bicyclische Spiroorthoester, Mono- oder Oligoepoxide oder Spiro-Silane der allgemeinen Formel X. Es können aber auch Verbindungen zugesetzt werden, die sowohl kationisch als auch radikalisch polymerisierbar sind, wie z.B. Methacryloyl-Spiroorthoester. Diese sind radikalisch über die C=C-Doppelbindung und kationisch unter Ringöffnung polymerisierbar. Diese Systeme sind z.B. im Journal f. prakt. Chemie, Band 330, Heft2, 1988, S. 316-318, oder im Journal of Polymer Science: Part C: Polymer Letters, Vol. 26, S. 517-520 (1988) beschrieben.

Ferner können den erfindungsgemäßen Silanen vor der Polymerisation weitere hydrolysierbare und polymerisierbare Verbindungen des siliciums zugesetzt werden, gegebenenfalls in vorkondensierter Form, die dann mit einpolymerisiert werden. Solche Silicium-Verbindungen leiten sich z.B. von Epoxid-haltigen Silanen ab, sind deshalb kationisch polymerisierbar und werden u.a. für die Herstellung der Spiro-Silane gemäß der DE 4125201 C1 eingesetzt. Diese Systeme sind in der DE 4125201 C1 beschrieben.

Es können aber auch Silicium-Verbindungen eingesetzt werden, die sich z.B. von solchen der allgemeinen Formel IX ableiten und radikalisch polymerisierbar sind. Diese Systeme sind bei der Herstellung der Poly(hetero)kondensate bereits näher beschrieben worden.

Die Polymerisation erfolgt kovalent-nucleophil und/oder redox-induziert und/oder thermisch und/oder photochemisch nach Zugabe geeigneter Initiatoren. Dabei werden z.B. im Zuge einer radikalischen Polymerisation C=C-Doppelbindungen verknüpft und gegebenenfalls im Zuge einer kationischen Polymerisation Ringe von Spiro-Gruppen und gegebenenfalls weitere radikalisch polymerisierbare Ringe geöffnet. Dadurch wird das organische Netzwerk aufgebaut. Überraschenderweise wurde festgestellt, daß sich im Laufe dieser Polymerisation das Volumen der Reaktionsmasse nicht oder nur geringfügig ändert. Verantwortlich dafür ist das relativ hohe Molekulargewicht der erfindungsgemäßen Silane.

Erfolgt die Polymerisation photochemisch, so werden der Reaktionsmasse Photoinitiatoren zugesetzt, erfolgt die Polymerisation thermisch, so werden thermische Initiatoren zugesetzt und bei redox-induzierter Polymerisation Starter/Aktivator-Systeme.

Wurden den erfindungsgemäßen Silanen Komponenten mit Spiro-Gruppen zugesetzt, so kann über diese ebenfalls eine Polymerisation ablaufen, die thermisch oder photochemisch initiierbar ist. Als Photoinitiatoren hierfür können z.B. die im Handel erhältlichen eingesetzt werden.

Der Initiator kann in üblichen Mengen zugegeben werden. So kann z.B. einer Mischung, die 30 bis 50 Gew.-% Feststoff (Polykondensat) enthält, Initiator in einer Menge von z.B. 0.5 bis 5 Gew.-%, insbesondere von 1 bis 3 Gew.-%, bezogen auf die Mischung zugesetzt, werden.

Das auf diese Weise erhaltene Polymerisat, Polyaddukt oder Polykondensat kann man nun zum Aufbau des anorganischen Netzwerkes, gegebenenfalls in Anwesenheit weiterer, hydrolytisch kondensierbarer Verbindungen des Siliciums und gegebenenfalls anderer Elemente aus der Gruppe B, Al, P, Sn, Pb, der Übergangsmetalle, der Lanthaniden und der Actiniden, und/oder von den oben genannten Verbindungen abgeleiteten Vorkondensaten, durch Einwirkung von Wasser oder Feuchtigkeit, gegebenenfalls in Anwesenheit eines Katalysators und/oder eines Lösungsmittels, hydrolytisch kondensieren. Die Polymerisate enthalten hydrolysierbare Gruppen X, z.B. Alkoxy-Gruppen, so daß damit ein anorganisches Netzwerk (Si-O-Si-Einheiten) aufgebaut werden kann.

Unter den gegebenenfalls eingesetzten hydrolysierbaren Verbindungen des Siliciums sind solche der allgemeinen Formel VIII, gegebenenfalls in vorkondensierter Form, bevorzugt. Diese Systeme wurden bereits bei der Herstellung der Poly(hetero)kondensate ausführlich beschrieben und mit konkreten Beispielen belegt.

Unter den gegebenenfalls eingesetzten hydrolysierbaren Aluminium-Verbindungen sind diejenigen besonders bevorzugt, die die allgemeine Formel AlR°₃ aufweisen, und geeignete hydrolysierbare Titan- oder Zirkonium-Verbindungen, die gegebenenfalls eingesetzt werden können, sind solche der allgemeinen Formel MX_{y}R_{z}. Auch diese Systeme wurden bereits bei der Herstellung der Poly(hetero)kondensate ausführlich abgehandelt.

Weitere hydrolysierbare Verbindungen, die dem Polymerisat, Polyaddukt oder Polykondensat zugesetzt werden können, sind z.B. Bortrihalogenide und Borsäureester, wie z.B. BCl₃, B(OCH₃)₃ und B(OC₂H₅)₃, Zinntetrahalogenide und Zinntetraalkoxide, wie z.B. SnCl₄ und Sn(OCH₃)₄, und Vanadyl-Verbindungen, wie z.B. VOCl₃ und VO(OCH₃)₃.

Auch hier kann, wie bereits erwähnt, die hydrolytische Kondensation in auf diesem Gebiet üblicher Art und Weise erfolgen. Die hydrolytische Kondensation kann in den meisten Fällen dadurch erfolgen, daß man dem zu hydrolysierenden Polymerisat, Polyaddukt oder Polykondensat, das entweder als solches oder gelöst in einem geeigneten Lösungsmittel vorliegt, das erforderliche Wasser bei Raumtemperatur oder unter leichter Kühlung direkt zugibt, vorzugsweise unter Rühren und in Anwesenheit eines Hydrolyse- und Kondensationskatalysators.

Bei Anwesenheit reaktiver Verbindungen von Al, Ti oder Zr empfielt sich in der Regel eine stufenweise Zugabe des Wassers. Unabhängig von der Reaktivität der anwesenden Verbindungen erfolgt die Hydrolyse in der Regel bei Temperaturen zwischen -20 und 130 °C, vorzugsweise zwischen 0 und 30 °C bzw. dem Siedepunkt des gegebenenfalls eingesetzten Lösungsmittels. Wie bereits angedeutet, hängt die beste Art und Weise der Zugabe von Wasser vor allem von der Reaktivität der eingesetzten Ausgangsverbindungen ab. So kann man z.B. das gelöste Polymerisat langsam zu einem Überschuß an Wasser tropfen oder man gibt Wasser in einer Portion oder portionsweise dem gegebenenfalls gelösten Polymerisat zu. Es kann auch nützlich sein, das Wasser nicht als solches zuzugeben, sondern mit Hilfe von wasserhaltigen organischen oder anorganischen Systemen in das Reaktionssystem einzutragen.

Die erfindungsgemäßen Polyfluoraryl-Silane sind aufgrund ihrer überraschend guten Löslichkeit, verglichen mit Polyfluoralkyl-Silanen, in herkömmlichen Lösungsmitteln und aufgrund ihrer Hydrolyse/Kondensationseigenschaften hervorragend als Precursor für die Herstellung fluorierter Organopolysiloxan-Lacke geeignet. Die mit den erfindungsgemäßen Silanen gefertigten Siloxan-Lacke sind gut handhabbar und eignen sich zur Herstellung optisch transparenter Formkörper, Beschichtungen etc. Es werden Materialien mit niedriger optischer Dämpfung erhalten, die in der optischen Datenverarbeitung, in der Telekommunikation und in der Aufbau- und Verbindungstechnik (z.B. als Buffer, Core, Cladding, optische Schalter, Verteiler oder Verstärker) eingesetzt werden können. Die mit den erfindungsgemäßen Silanen gefertigten Materialien sind kompatibel zur Aufbau-, Verbindungs- und Dünnfilmtechnik, sie sind photolithographisch strukturier- und replizierbar.

Überraschenderweise wurde festgestellt, daß die Herstellung der fluorierten Polysiloxan-Lacke mit Hilfe der erfindungsgemäßen Silane sehr einfach erfolgen kann, ohne daß Lösungen der Silane in speziellen Lösungsmitteln erzeugt werden müssen, wie dies bei Polyfluoralkylsilanen der Fall ist. Die erfindungsgemäßen Silane lassen sich problemlos mit Organoalkoxy-Silanen nach dem Stand der Technik mischen und in Standardlösungsmitteln (z.B. Ether, Ethanol, Aceton, Alkane, etc.) lösen. Dadurch sind sie hervorragend zur Synthese von Kieselsäure(hetero)polysiloxanen geeignet. Ebenso ist es möglich, die erfindungsgemäßen Silane gemeinsam mit Fluoraryl-Silanen nach dem Stand der Technik zu verarbeiten.

Die mit Hilfe der erfindungsgemäßen Silane gefertigten Lacke eignen sich sowohl zur Herstellung von Formkörpern, als auch zur Herstellung von Beschichtungen. Die mit den erfindungsgemäßen Silanen gefertigten Kieselsäure(hetero)polykondensaten sind in ihrer optischen Transparenz Kieselsäure(hetero)polykondensaten nach dem Stand der Technik weit überlegen und weisen stark verbesserte Dämpfungswerte auf. Der mit den erfindungsgemäßen Silanen gefertigte Lack ist lagerstabil und kann bei Bedarf gehärtet werden.

Mit erfindungsgemäßen, mehrfach funktionellen Silanen stehen Ausgangsverbindungen zur Verfügung, die die Herstellung von anorganisch-organischen Verbundpolymeren mit den unterschiedlichsten und in weiten Bereichen einstellbaren Eigenschaften bzw. die Modifikation von bestehenden Verbundpolymeren ermöglichen. Der Einsatz solcher Materialien erstreckt sich auf die verschiedensten Zwecke und unter anderem auf die Verwendung als Bulkmaterialien, Komposite, Klebstoffe, Vergußmassen, Beschichtungsmaterialien, Haftvermittler und Bindemittel für keramische Partikel (keramische Formgebungsverfahren), zur Herstellung bzw. Primung von Füllstoffen und Fasern, von Schleifscheiben, als Einsatz im Reaktionsextruder etc.. Für die organische Polymerisation kommt die photochemisch, die thermisch sowie die chemisch (2-Komponenten, anaerob, Redox, etc.) induzierte Umsetzung in Frage. Die Kombination von Selbsthärtung mit z.B. photoinduzierter bzw. thermischer Härtung ist ebenfalls möglich.

Anhand von Ausführungsbeispielen werden die Herstellung der erfindungsgemäßen Silane und deren Verwendung zur Herstellung von Kieselsäure(hetero)polykondensaten näher erläutert.

### Beispiel 1:

### Synthese des p-Vinyl-tetrafluorophenyl-triethoxysilan

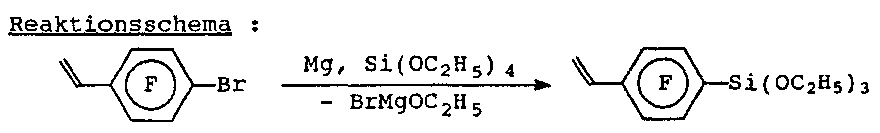

25.5 g (100 mmol) 4-Brom-2.3.5.6-tetrafluorstyrol, 4.86 g (200 mmol) Magnesiumspäne, 125.0 g (600 mmol) Tetraethoxysilan und ca. 4 g 1.2-Dibromethan werden in 150 ml Ether gemischt und solange unter Rückfluß erhitzt, bis eine exotherme Reaktion auftritt. Es werden innerhalb einer Stunde weitere Portionen 1.2 Dibromethan (insgesamt 18.79 g ≙ 100 mmol) zugegeben, und nach Beendigung der exothermen Reaktion wird noch 16 h unter Rückfluß erhitzt. Nach Abkühlen auf Raumtemperatur werden die entstandenen Magnesiumsalze durch Zugabe von n-Heptan gefällt, abfiltriert und das Lösungsmittel abdestilliert. Der Rückstand wird im Vakuum fraktioniert destilliert. Die Identifizierung erfolgte mittels IR-, ¹H-NMR-, ¹³C-NMR- und ¹⁹F-NMR-Spektroskopie und Elementaranalyse.
Ausbeute : 11.84 g (35 %);
Sdp.: 67 °C (0.1 mbar)

### Beispiel 2:

### Synthese des Methacrylsäure-[4-(triethoxysilyl)]-tetrafluorphenylesters

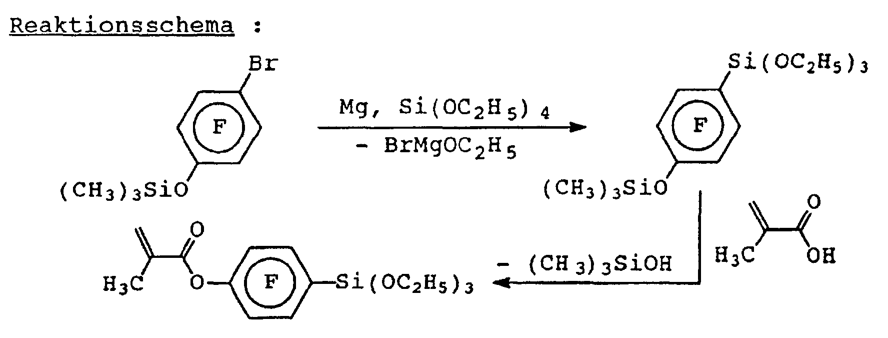

31.72 g (100 mmol) (4-Brom-2.3.5.6-tetrafluorphenoxy)-trimethylsilan, 4.86 g (200 mmol) Magnesiumspäne, 125.0 g (600 mmol) Tetraethoxysilan und ca. 4 g 1.2-Dibromethan werden in 150 ml Ether gemischt und solange unter Rückfluß erhitzt, bis eine exotherme Reaktion auftritt. Es werden innerhalb einer Stunde weitere Portionen 1.2 Dibromethan (insgesamt 18.79 g ≙ 100 mmol) zugegeben, und nach Beendigung der exothermen Reaktion wird noch 16 h unter Rückfluß erhitzt. Nach Abkühlen auf Raumtemperatur werden die entstandenen Magnesiumsalze durch Zugabe von n-Heptan gefällt, abfiltriert und das Lösungsmittel abdestilliert. Der Rückstand wird im Vakuum fraktioniert destilliert.
Ausbeute : 12.41 g (31 %) (p-Triethoxysilyl)-tetrafluorphenoxy-trimethylsilan;
Sdp.: 80 °C (0.1 mbar)

12.02 g (30 mmol) (p-Triethoxysilyl)-tetrafluorphenoxy-trimethylsilan und 36.86 g (800 mmol) abs. Ethanol werden 1.5 h unter Rückfluß erhitzt. Nach vollständiger Entfernung des Lösungsmittels im Vakuum wird das erhaltene Rohprodukt in 40 ml Trichlorethan gelöst und bei 0 °C werden 2.53 g Pyridin zugegeben. Dann werden 3.35 g (32 mmol) Methacrylsäure bei 0 °C zugetropft und danach wird noch 16 h bei Raumtemperatur gerührt. Nach Filtrieren des entstandenen Niederschlages wird das Lösungsmittel abdestilliert und der Rückstand im Vakuum fraktioniert destilliert. Die Identifizierung erfolgte mittels IR-, ¹H-NMR-, ¹³C-NMR- und ¹⁹F-NMR-Spektroskopie und Elementaranalyse.
Ausbeute: 8.56 g (72 %) Methacrylsäure-[4-(triethoxysilyl)]-tetrafluorphenylester.
Sdp.: 95 °C (0.1 bar)

### Beispiel V (nicht erfindungsgemäß)

Herstellung eines teilfluorierten Organopolysiloxan-Lacks aus

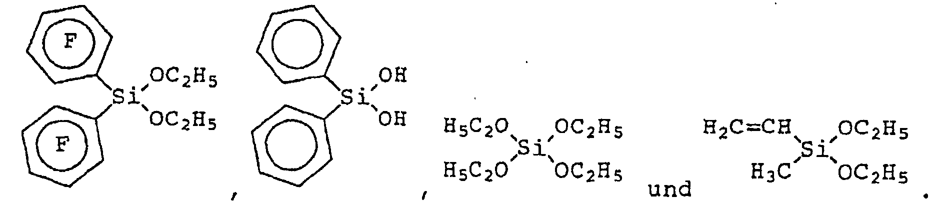

Ein Gemisch aus 20 mmol Dipentafluorphenyldiethoxysilan, 20 mmol Vinylmethyldiethoxysilan, 5 mmol Diphenylsilandiol und 5 mmol Tetraethoxysilan werden mit 95 mmol Wasser hydrolysiert und kondensiert.

### Beispiel 3:

### Herstellung eines hochfluorierten Organopolysiloxan-Lacks aus

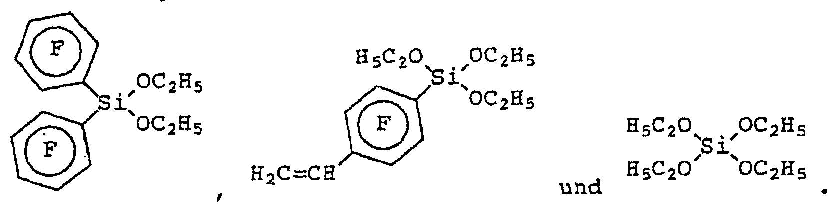

Ein Gemisch aus 30 mmol Dipentafluorphenyldiethoxysilan, 20 mmol p-Vinyl-tetrafluorphenyl-triethoxysilan und 5 mmol Tetraethoxysilan werden mit 140 mmol Wasser hydrolysiert und kondensiert.

## Patentansprüche

1. Silane der allgemeinen Formel I
{[R'-(Y)ₑ]_{c+1}(C₆F_{4-c})(C₆F₄)_{d}}_{f}SiRₐX_{b} (I)
oder der allgemeinen Formel VI:
{[R'-(Y)ₑ[X_{3-g}R_{g}Si-(Y)ₑ](C₆F₃)(C₆F₄)_{d}}_{f}SiRₐX_{b} (VI)
in der die Reste und Indices gleich oder verschieden sind und folgende Bedeutung haben:
R = gebenenfalls substituiertes Alkyl, Alkenyl, Aryl, Alkylaryl oder Arylalkyl mit jeweils 1 bis 20 Kohlenstoff-Atomen, wobei diese Reste durch Sauerstoff- oder Schwefelatome, durch Ester-, Carbonyl-, Amid- oder Aminogruppen unterbrochen sein können;
R'= ein organischer Rest, der 1 bis 50 Kohlenstoffatome und wenigstens eine C=C-Doppelbindung und/oder wenigstens eine Spiro-Gruppe und/oder wenigstens einen substituierten oder unsubstituierten Oxiran-Rest enthält;
X = Wasserstoff, Halogen, Hydroxy, Alkoxy, Acyloxy, Alkylcarbonyl, Alkoxycarbonyl oder NR"₂, mit R" = Wasserstoff, Alkyl oder Aryl;
Y = O, S, NH oder NR', wobei R' ein organischer Rest mit 1 bis 50 Kohlenstoff-Atomen ist;
a = 0, 1 oder 2;
b = 1, 2 oder 3;
c = 0 oder 1;
d = 0 bis 9;
e = 0 oder 1;
f = 1, 2 oder 3, mit a+b+f = 4
g = 0, 1, 2 oder 3.

2. Silane nach Anspruch 1, **dadurch gekennzeichnet, daß** einer oder mehrere der Reste R' wenigstens einen perfluorierten Alkyl-, Alkenyl- oder Aryl-Rest enthält.

3. Silane nach Anspruch 1, **dadurch gekennzeichnet, daß** einer oder mehrere der Reste R' SiRₕX₂₋ₕ{(C₆F₄)_{d}(C₆F_{4-c})[(Y)ₑ-R']_{c+1}} bedeutet, mit h = 0, 1 oder 2, wobei die übrigen Reste und Indices gleich oder verschieden und wie in Anspruch 1 definiert sind.

4. Verfahren zur Herstellung der Silane nach Anspruch 1, **dadurch gekennzeichnet, daß** man Verbindungen der allgemeinen Formel II,
{[R'-Y)ₑ]_{c+1}(C₆F_{4-c})(C₆F₄)_{d}}-Hal (II)
in der Hal Halogen bedeutet und die übrigen Reste und Indices gleich oder verschieden und wie in Anspruch 1 definiert sind, mit elementarem Magnesium zu Grignard-Verbindungen der allgemeinen Formel III umsetzt,
{[R'-(Y)ₑ]_{c+1}(C₆F_{4-c})(C₆F₄)_{d}}-Mg-Hal (III)
und diese mit Silanen der allgemeinen Formel IV,
SiRₐX_{b+f} (IV)
in der die Reste und Indices gleich oder verschieden und wie in Anspruch 1 definiert sind, unter Eleminierung von Hal-Mg-X reagieren läßt.

5. Verwendung der Silane nach einem oder mehreren der Ansprüche 1 bis 3 zur Herstellung von Kieselsäurepolykondensaten oder von Kieselsäureheteropolykondensaten durch hydrolytische Kondensation einer oder mehrerer hydrolytisch kondensierbarer Verbindungen des Siliciums und gegebenenfalls anderer Elemente aus der Gruppe B, Al, P, Sn, Pb, der Übergangsmetalle, der Lanthaniden und der Actiniden, und/oder von den oben genannten Verbindungen abgeleiteten Vorkondensaten, gegebenenfalls in Anwesenheit eines Katalysators und/oder eines Lösungsmittels, durch Einwirkung von Wasser oder von Feuchtigkeit, **dadurch gekennzeichnet, daß** 1 bis 100 Mol-%, auf der Basis monomerer Verbindungen, der hydrolytisch kondensierbaren Verbindungen aus Silanen der allgemeinen Formel I ausgewählt werden,
{[R'-(Y)ₑ]_{c+1}(C₆F_{4-c})(C₆F₄)_{d}}_{f}SiRₐX_{b} (I)
in der die Reste und Indices wie in Anspruch 1 definiert sind.

6. Verwendung nach Anspruch 5, **dadurch gekennzeichnet, daß** man als weitere hydrolytisch kondensierbare Verbindungen polyaddierbare und/oder polymerisierbare und/oder polykondensierbare Verbindungen einsetzt, gegebenenfalls in vorkondensierter Form.

7. Verwendung nach Anspruch 5 oder 6, **dadurch gekennzeichnet, daß** man als weitere hydrolytisch kondensierbare Komponente eine oder mehrere, im Reaktionsmedium lösliche Aluminium, Titan- oder Zirkoniumverbindungen, gegebenenfalls in vorkondensierter Form, der Formel
AlR^{°} ₃ oder M X_{y} R_{z}
einsetzt, in der M Titan oder Zirkonium bedeutet, die Reste R, R° und X gleich oder verschieden sind, R° Halogen, Hydroxy, Alkoxy oder Acyloxy darstellt, y eine ganze Zahl von 1 bis 4 ist, insbesondere 2 bis 4, z für 0, 1, 2 oder 3 steht, vorzugsweise für 0, 1 oder 2, und X und R wie im Falle der allgemeinen Formel I definiert sind.

8. Verwendung nach einem oder mehreren der Ansprüche 5 bis 7, **dadurch gekennzeichnet, daß** man dem Polykondensat gegebenenfalls eine oder mehrere polymerisierbare und/oder polyaddierbare und/oder polykondensierbare Komponenten zusetzt.

9. Verwendung der Silane nach einem oder mehreren der Ansprüche 1 bis 3 zur Herstellung von Bulkmaterialien, Kompositen, Klebstoffen, Verguß- und Dichtungsmassen, Beschichtungsmaterialien, Schleifmitteln, Beschichtungen, Haftvermittlern, Füllstoffen, Fasern, Folien, Contact(Linsen) und Bindemitteln für Partikel.

10. Verwendung der Silane nach einem oder mehreren der Ansprüche 1 bis 3 zur Herstellung von Materialien für optische oder optoelektronische Bauteile.

## Claims

1. Silanes of the general formula I
{[R'-(Y)ₑ]_{c+1} (C₆F_{4-c})(C₆F₄)_{d}}_{f}SiRₐX_{b} (I)
or of the general formula (VI):
{[R'-(Y)ₑ][X_{3-g}R_{g}Si-(Y)ₑ](C₆F₃)(C₆F₄)_{d}}_{f}SiRₐX_{b} (VI)
in which the radicals and indices are the same or different and have the following meaning:
R = optionally substituted alkyl, alkenyl, aryl, alkylaryl or arylalkyl having in each case 1 to 20 carbon atoms, wherein these radicals may be interrupted by oxygen or sulphur atoms, by ester, carbonyl, amide or amino groups;
R' = an organic radical which contains 1 to 50 carbon atoms and at least one C=C double bond and/or at least one spiro group and/or at least one substituted or unsubstituted oxirane radical;
X= hydrogen, halogen, hydroxy, alkoxy, acyloxy, alkylcarbonyl, alkoxycarbonyl or NR"₂, where R" = hydrogen, alkyl or aryl;
Y = O, S, NH or NR', wherein R' is an organic radical having 1 to 50 carbon atoms;
a = 0, 1 or 2;
b = 1, 2 or 3;
c = 0 or 1;
d = 0 to 9;
e = 0 or 1;
f = 1, 2 or 3, where a+b+f = 4;
g = 0, 1, 2 or 3.

2. Silanes according to claim 1, **characterised in that** one or more of the radicals R' contains at least one perfluorinated alkyl, alkenyl or aryl radical.

3. Silanes according to claim 1, **characterised in that** one or more of the radicals R' denotes SiRₕX₂₋ₕ{(C₆F₄)_{d}(C₆F_{4-c})[(Y)ₑ-R']_{c+1}}, where h = 0, 1 or 2, wherein the remaining radicals and indices are the same or different and as defined in claim 1.

4. Process for producing the silanes according to claim 1, **characterised in that** compounds of the general formula II,
{[R'-(Y)ₑ]_{c+1}(C₆F_{4-c})(C₆F₄)_{d}}-Hal (II)
in which Hal denotes halogen and the remaining radicals and indices are the same or different and as defined in claim 1, are reacted with elemental magnesium to form Grignard compounds of the general formula III,
{[R'-(Y)ₑ]_{c+1}(C₆F_{4-c})(C₆F₄)_{d}}-Mg- Hal (III)
and the latter can be reacted with silanes of the general formula IV,
SiRₐX_{b+f} (IV)
in which the radicals and indices are the same or different and as defined in claim 1, with elimination of Hal-Mg-X.

5. Use of the silanes according to one or more of claims 1 to 3 for producing silicic acid polycondensates or silicic acid heteropolycondensates by hydrolytic condensation of one or more hydrolytically condensable compounds of silicon and optionally other elements from the group B, Al, P, Sn, Pb, the transition metals, the lanthanides and the actinides, and/or precondensates derived from the above-mentioned compounds, optionally in the presence of a catalyst and/or a solvent, by action of water or of moisture, **characterised in that** 1 to 100 mole%, on the basis of monomer compounds, of the hydrolytically condensable compounds are selected from silanes of the general formula I,
{[R'-(Y)ₑ]_{c+1}(C₆F_{4-c})(C₆F₄)_{d}}_{f}SiRₐX_{b} (I)
in which the radicals and indices are as defined in claim 1.

6. Use according to claim 5, **characterised in that** polyaddable and/or polymerisable and/or polycondensable compounds are used as further hydrolytically condensable compounds, optionally in precondensed form.

7. Use according to claim 5 or 6, **characterised in that** one or more aluminium, titanium or zirconium compounds which are soluble in the reaction medium are used as further hydrolytically condensable compounds, optionally in precondensed form, of the formula
AlR°₃ or MX_{y}R_{z}
in which M denotes titanium or zirconium, the radicals R, R° and X are the same or different, R° represents halogen, hydroxy, alkoxy or acyloxy, y is a whole number from 1 to 4, in particular 2 to 4, z represents 0, 1, 2 or 3, preferably 0, 1 or 2, and X and R are defined as in the case of the general formula I.

8. Use according to one or more of claims 5 to 7, **characterised in that** optionally one or more polymerisable and/or polyaddable and/or polycondensable components are added to the polycondensate.

9. Use of the silanes according to one or more of claims 1 to 3 for producing bulk materials, composites, adhesives, casting and sealing compositions, coating materials, polishing materials, coatings, adhesion promoters, fillers, fibres, films, contact (lenses) and binders for particles.

10. Use of the silanes according to one or more of claims 1 to 3 for producing materials for optical or optoelectronic components.

## Revendications

1. Silanes de formule générale I
{[R'-(Y)ₑ]_{c+1}(C₆F_{4-c})(C₆F₄)_{d}}_{f}SiRₐX_{b} (I)
ou de formule générale (VI) :
{[R'-(Y)ₑ][X_{3-g}R_{g}Si-(Y)ₑ](C₆F₃)(C₆F₄)_{d}}_{f}SiRₐX_{b} (VI)
dans laquelle les restes et les indices sont identiques ou différents et ont la définition suivante :
R = reste alkyle, alcényle, aryle, alkylaryle ou arylalkyle éventuellement substitué ayant chacun 1 à 20 atomes de carbone, ces restes pouvant être interrompus par des atomes d'oxygène ou de soufre, par des groupes ester, carbonyle, amide ou amino ;
R' = reste organique qui contient 1 à 50 atomes de carbone et au moins une double liaison C=C et/ou au moins un groupe spiro et/ou au moins un reste oxiranne substitué ou non substitué ;
X = hydrogène, halogène, hydroxy, alkoxy, acyloxy, alkylcarbonyle, alkoxycarbonyle ou NR"₂, avec R" = hydrogène, alkyle ou aryle ;
Y = O, S, NH ou NR', R' désignant un reste organique ayant 1 à 50 atomes de carbone ;
a = 0, 1 ou 2 ;
b = 1, 2 ou 3 ;
c = 0 ou 1 ;
d = 0 à 9 ;
e = 0 ou 1 ;
f = 1, 2 ou 3, avec a+b+f = 4,
g = 0, 1, 2 ou 3.

2. Silanes suivant la revendication 1, **caractérisés en ce qu'**un ou plusieurs des restes R' contiennent au moins un reste alkyle, alcényle ou aryle perfluoré.

3. Silanes suivant la revendication 1, **caractérisés en ce qu'**un ou plusieurs des restes R' désignent un reste SiRₕX₂₋ₕ{(C₆F₄)_{d}(C₆F_{4-c})[(Y)eR']_{c+1}}, où h est égal à 0, 1 ou 2, les autres restes et indices étant identiques ou différents et tels que définis dans la revendication 1.

4. Procédé de production des silanes suivant la revendication 1, **caractérisé en ce qu'**on fait réagir des composés de formule générale II
{[R'-(Y)ₑ]_{c+1}(C₆F_{4-c}) (C₆F₄)_{d}}-Hal (II)
dans laquelle Hal désigne un halogène et les autres restes et indices sont identiques ou différents et tels que définis dans la revendication 1, avec du magnésium élémentaire pour former des composés de Grignard de formule générale III
{[R'-(Y)ₑ]_{c+1}(C₆F_{4-c})(C₆F₄)_{d}}-Mg-Hal (III)
et on fait réagir ces composés avec des silanes de formule générale IV
SiRₐX_{b+f} (IV)
dans laquelle les restes et indices sont identiques ou différents et tels que définis dans la revendication 1, avec élimination de Hal-Mg-X.

5. Utilisation des silanes suivant l'une ou plusieurs des revendications 1 à 3, pour la production de polycondensats d'acide silicique ou d'hétéropolycondensats d'acide silicique par condensation hydrolytique d'un ou plusieurs composés, susceptibles de condensation hydrolytique, du silicium et, le cas échéant, d'autres éléments du groupe B, Al, P, Sn, Pb, des métaux de transition, des lanthanides et des actinides, et/ou de précondensats dérivés des composés mentionnés ci-dessus, le cas échéant, en présence d'un catalyseur et/ou d'un solvant, par l'action de l'eau ou de l'humidité, **caractérisée en ce qu'**une proportion de 1 à 100 moles %, sur la base des composés monomères, des composés susceptibles de condensation hydrolytique, est choisie parmi des silanes de formule générale I
{[R'-(Y)ₑ]_{c+1}(C₆F_{4-c})(C₆F₄)_{d}}_{f}SiRₐX_{b} (I)
dans laquelle les restes et indices sont tels que définis dans la revendication 1.

6. Utilisation suivant la revendication 5, **caractérisée en ce qu'**on utilise comme autres composés susceptibles de condensation hydrolytique des composés polyadditionnables et/ou polymérisables et/ou polycondensables, éventuellement sous la forme précondensée.

7. Utilisation suivant la revendication 5 ou 6, **caractérisée en ce qu'**on utilise comme autres composants susceptibles de condensation hydrolytique un ou plusieurs composés d'aluminium, de titane ou de zirconium solubles dans le milieu réactionnel, éventuellement sous la forme précondensée, de formule
AlR°₃ ou M X_{y} R_{z}
dans laquelle M désigne le titane ou le zirconium, les restes R, R° et X sont identiques ou différents, R° représente un halogène, un reste hydroxy, alkoxy ou acyloxy, y est un nombre entier de 1 à 4, notamment de 2 à 4, z a la valeur 0, 1, 2 ou 3, de préférence la valeur 0, 1 ou 2 et X et R ont les mêmes définitions que dans le cas de la formule générale I.

8. Utilisation suivant l'une ou plusieurs des revendications 5 à 7, **caractérisée en ce qu'**on ajoute au polycondensat, le cas échéant, un ou plusieurs composants polymérisables et/ou polyadditionnables et/ou polycondensables.

9. Utilisation des silanes suivant l'une ou plusieurs des revendications 1 à 3, pour la production de matières en vrac, de composites, d'adhésifs, de matières de scellement et d'étanchéité, d'enduits, d'abrasifs, de revêtements, d'agents de pontage, de charges, de fibres, de feuilles, de produits (lentilles) de contact et de liants pour particules.

10. Utilisation des silanes suivant l'une ou plusieurs des revendications 1 à 3, pour la production de matières pour éléments optiques ou opto-électriques.
